# EUROPEAN PATENT APPLICATION

(11) **EP 4 642 202 A1**
(43) Date of publication of application: **29.10.2025**
(21) Application number: 25172441.5
(22) Date of filing: 24.04.2025
(51) Int. Cl.: H10K 59/122

(54) **DISPLAY DEVICE AND ELECTRONIC DEVICE INCLUDING THE SAME**

(30) Priority: 26.04.2024 KR 20240055846
(71) Applicant: Samsung Display Co., Ltd., Yongin-si, Gyeonggi-do 17113 (KR)
(72) Inventor: LEE, JEONGHYUN, 17113 Yongin-si (KR); KWAK, NARAE, 17113 Yongin-si (KR); KIM, MIKYUNG, 17113 Yongin-si (KR); PARK, YONGSUNG, 17113 Yongin-si (KR); JUNG, JOOHYE, 17113 Yongin-si (KR)
(74) Representative: Taor, Simon Edward William

(57) **Abstract**

Provided is a display device comprising a base layer in which a plurality of pixel regions comprising a first pixel region and a second pixel region adjacent to the first pixel region and a non-pixel region are defined, a pixel-defining film above the base layer, overlapping the non-pixel region, and having a pixel opening defined therein, and a light-emitting element layer located at least partially within the pixel opening. A first valley pattern overlapping the non-pixel region and surrounding a portion of the first pixel region is defined in the pixel-defining film. The first pixel region comprises a first lateral side extending in a first direction, and a first portion of the first valley pattern comprises a first extension portion extending along the first direction, a second extension portion extending from the first extension portion in a second direction crossing the first direction, and a third extension portion extending from the second extension portion in the first direction.

## Description

### CROSS-REFERENCE TO RELATED APPLICATION

The present application claims priority to, and the benefit of, Korean Patent Application No. 10-2024-0055846, filed on April 26, 2024, in the Korean Intellectual Property Office.

### BACKGROUND

The present disclosure herein relates to a display device and an electronic device including the same, including to a display device and an electronic device in which color mixing between adjacent pixels is reduced or prevented and display quality is improved.

Electronic devices, such as smart phones, tablets, digital cameras, laptop computers, navigation systems, and televisions, which provide images to users, include display devices for displaying images.

In a display device, pixels may be divided into red, green, and blue pixels for color display, and a light-emitting layer corresponding to each color may be provided for each pixel. In general, a deposition method using a shadow mask is used for the light-emitting layer, but defects such as sagging of the mask may occur. Therefore, a process has been developed in which the light-emitting layer and an additional organic layer are provided in common in all pixels by using an open mask.

However, if the organic layer is provided in common, a lateral leakage current may occur due to the organic layer commonly provided between adjacent pixels, and because of this, color mixing and luminance defects may occur between adjacent pixels.

### SUMMARY

The present disclosure provides a display device and an electronic device in which color mixing between adjacent pixels may be reduced or prevented and display defects may be reduced or prevented from occurring in an initial driving stage.

One or more embodiments provides a display device including a base layer having a first pixel region including a first lateral side extending in a first direction, a second pixel region adjacent to the first pixel region, and a non-pixel region surrounding the first pixel region and the second pixel region, a pixel-defining film above the base layer, overlapping the non-pixel region, defining a pixel opening therein and corresponding to the first pixel region or the second pixel region, and defining a first valley pattern overlapping the non-pixel region and surrounding a portion of the first pixel region in plan view, a first portion of the first valley pattern adjacent to the first lateral side including a first extension portion extending along the first direction, a second extension portion extending from the first extension portion in a second direction crossing the first direction so as to be away from the first lateral side, and a third extension portion extending from the second extension portion in the first direction and parallel to the first extension portion, and a light-emitting element layer at least partially within the pixel opening.

A length of the second extension portion in the second direction may be less than a length of the first extension portion in the first direction.

The first portion may further include a fourth extension portion extending from the third extension portion in the second direction so as to be away from the first lateral side, and a fifth extension portion extending from the fourth extension portion in the first direction and parallel to the third extension portion.

The first valley pattern may include a second portion connected to the first portion on a plane, wherein the second portion includes a sixth extension portion extending from the fifth extension portion in the first direction, a seventh extension portion extending from the sixth extension portion in the second direction toward the first lateral side, an eighth extension portion extending from the seventh extension portion in the first direction and parallel to the sixth extension portion, a ninth extension portion extending from the eighth extension portion in the second direction toward the first lateral side, and a tenth extension portion extending from the ninth extension portion in the first direction and parallel to the eighth extension portion.

The second extension portion and the ninth extension portion may be spaced apart at a constant distance.

The first extension portion and the tenth extension portion may be aligned in the first direction, wherein the third extension portion and the eighth extension portion are aligned in the first direction, and wherein the fifth extension portion and the sixth extension portion are aligned in the first direction.

The first valley pattern may have a shape recessed from an upper surface of the pixel-defining film along a thickness direction of the pixel-defining film.

A depth of the first valley pattern recessed from the upper surface of the pixel-defining film may be about 100 nm to about 500 nm.

The first valley pattern may include a lower surface parallel to the upper surface of the pixel-defining film, and a side surface connecting the lower surface to the upper surface of the pixel-defining film, and an angle at which the side surface is inclined from the lower surface is about 70 degrees to about 90 degrees.

The light-emitting element layer may include a first electrode above the base layer, an organic layer above the first electrode and the pixel-defining film and including a light-emitting layer, and a second electrode above the organic layer, wherein a portion of the organic layer and the second electrode is within the first valley pattern.

The organic layer may include a first organic portion above the upper surface of the pixel-defining film, and a second organic portion on the side surface, and having a thickness that is less than a thickness of the first organic portion.

The second electrode may include a first electrode portion above the upper surface of the pixel-defining film, and a second electrode portion on the side surface, and having a thickness that is less than a thickness of the first electrode portion.

The organic layer may include a first light-emitting stack above the first electrode and the pixel-defining film, and including a first light-emitting layer, a first charge generation layer above the first light-emitting stack, and a second light-emitting stack between the first charge generation layer and the second electrode, and including a second light-emitting layer.

The pixel-defining film may further define a second valley pattern overlapping the non-pixel region, and surrounding a portion of the second pixel region in plan view, wherein a first open portion in which the first valley pattern does not surround the first pixel region does not face a second open portion in which the second valley pattern does not surround the second pixel region.

The base layer may further have a third pixel region adjacent to the second pixel region, wherein the pixel-defining film further defines a third valley pattern overlapping the non-pixel region, and surrounding a portion of the third pixel region in plan view.

The first pixel region may be configured to emit a first light, wherein the second pixel region is configured to emit a second light of a wavelength different from that of the first light, and wherein the third pixel region is configured to emit a third light of a wavelength different from those of the first light and the second light.

In one or more embodiments, a display device includes a base layer having a first pixel region including a first lateral side extending in a first direction, a second pixel region adjacent to the first pixel region, and a non-pixel region surrounding the one or more pixel regions in plan view, a pixel-defining film above the base layer, overlapping the non-pixel region, defining a pixel opening corresponding to the first pixel region and the second pixel region, and defining a first valley pattern overlapping the non-pixel region, surrounding a portion of the first pixel region in plan view, and including a first portion adjacent to the first lateral side and having an S-shape on a plane, and a second portion connected to the first portion and having a shape symmetrical to the first portion with respect to a virtual axis extending in a second direction crossing the first direction, and a light-emitting element layer at least partially within the pixel opening.

The pixel-defining film may further define second valley pattern overlapping the non-pixel region and surrounding a portion of the second pixel region in plan view, wherein the second pixel region includes a second lateral side extending in the first direction, and wherein the second valley pattern includes a third portion adjacent to the second lateral side and having an S-shape on a plane, and a fourth portion connected to the third portion and having a shape symmetrical to the third portion with respect to a virtual axis extending in the second direction.

The first valley pattern may include multiple first portions and multiple second portions in an alternating arrangement along the first direction.

According to an aspect, there is provided a display device as set out in claim 1. Additional features are set out in claims 2 to 15.

In one or more embodiments, an electronic device includes a base layer having a first pixel region including a first lateral side extending in a first direction, a second pixel region adjacent to the first pixel region, and having a non-pixel region surrounding the first pixel region and the second pixel region, a pixel-defining film above the base layer, overlapping the non-pixel region, having a pixel opening defined therein and corresponding to the one or more pixel regions, and defining a first valley pattern overlapping the non-pixel region, surrounding a portion of the first pixel region in plan view, having a shape recessed from an upper surface of the pixel-defining film along a thickness direction of the pixel-defining film, and including an S-shaped first portion adjacent to the first lateral side, and a light-emitting element layer at least partially within the pixel opening.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain aspects of the present disclosure. In the drawings:
FIG. 1 is a combined perspective view of an electronic device in accordance with various aspects described herein;
FIG. 2 is an exploded perspective view of the electronic device of FIG. 1 and illustrating a display module in accordance with various aspects described herein;
FIG. 3 is a block diagram of the electronic device of FIG. 1;
FIG. 4 is a block diagram of the display module of FIG. 2;
FIG. 5 is a cross-sectional view of the display module of FIG. 2;
FIG. 6A is a cross-sectional view of a portion of a display panel included in the display module of FIG. 2;
FIG. 6B is a cross-sectional view of a portion of another display panel suitable for use with the display module of FIG. 2 in accordance with various aspects described herein;
FIG. 7 is a cross-sectional view of a light-emitting element included in the display module of FIG. 2;
FIG. 8A is an enlarged plan view of a portion AA' of the display module of FIG. 2 and illustrating pixel regions in accordance with various aspects described herein;
FIG. 8B is an enlarged view illustrating a portion of the pixel regions of FIG. 8A;
FIG. 9A is an enlarged plan view of the portion BB' of FIG. 8B. and illustrating a first pixel region in accordance with various aspects described herein;
FIG. 9B is another enlarged plan view of the portion BB' of FIG. 8B and illustrating a first valley pattern, adjacent to the first pixel region of FIG. 9A, in accordance with various aspects described herein.
FIG. 10 is an enlarged plan view of the portion CC' of FIG. 8B and illustrating a second pixel region and a second valley pattern in accordance with various aspects described herein;
FIG. 11 is a cross-sectional view of the portion BB' of FIG. 9A along line I-I'; and
FIG. 12 is a cross-sectional view of the portion shown in FIG. 8B along line II-II'.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

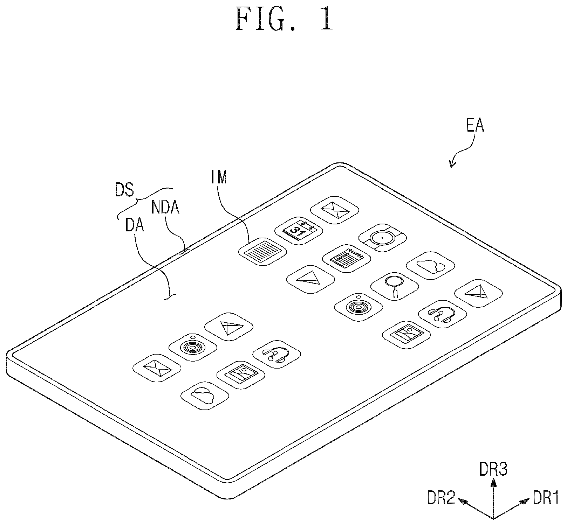

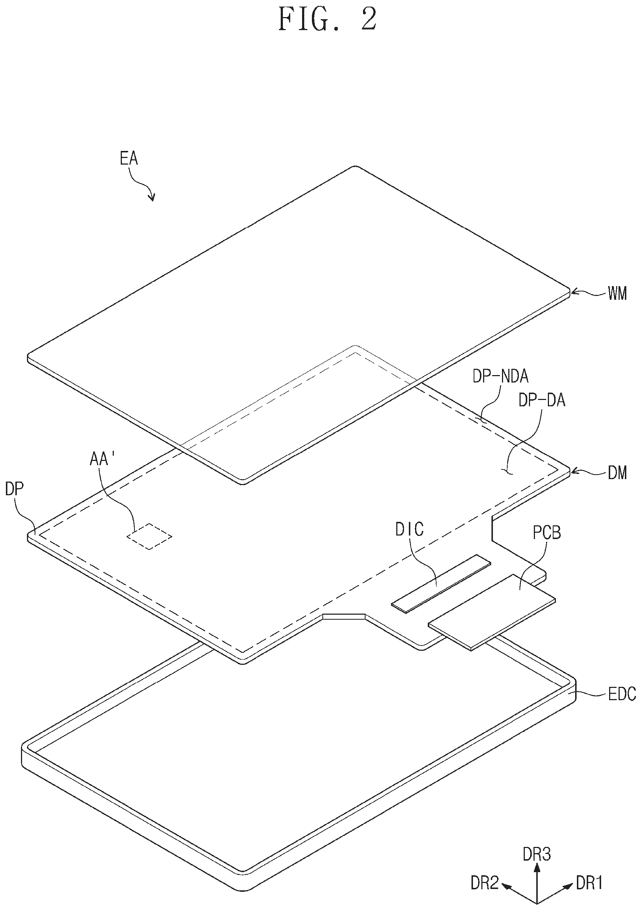

FIG. 1 is a combined perspective view of an electronic device according to one or more embodiments. FIG. 2 is an exploded perspective view of the electronic device according to one or more embodiments.

Referring to FIG. 1, the electronic device EA may be activated according to an electrical signal. The electronic device EA may display an image IM and sense an external input. The electronic device EA may include various embodiments. In the non-limiting example shown, the electronic device EA is illustrated as a tablet. Without being limited thereto, however, the electronic device EA according to one or more embodiments may be a smartphone. Alternatively, the electronic device according to one or more embodiments may be a large display device, such as a laptop, a monitor, or a television. Meanwhile, while FIG. 1 illustrates a rigid electronic device EA, the electronic device EA according to embodiments is not limited thereto and may be a flexible electronic device in which the shape of at least a partial region thereof changes depending on the mode of use.

The electronic device EA may display an image IM toward a third direction DR3 on a display surface DS parallel to each of a first direction DR1 and a second direction DR2. The display surface DS on which the image IM is displayed may correspond to a front surface of the electronic device EA and a front surface FS of a window WM. Hereinafter, a same reference numeral is used for the display surface of the electronic device EA, the front surface thereof, and the front surface FS of the window WM. The image IM may include a static image as well as a dynamic image. In Figure 1, a plurality of icons are illustrated as an example of the image IM.

The front (or upper) and rear (or lower) surfaces of each member are defined based on a direction in which the image IM is displayed. The front and rear surfaces thereof may be opposed to each other in the third direction DR3, and the normal direction of each of the front and rear surfaces may be parallel to the third direction DR3. The separation distance between the front and rear surfaces in the third direction DR3 may correspond to the thickness of the electronic device EA in the third direction DR3. Meanwhile, directions indicated by the first to third directions DR1, DR2, and DR3 are relative concepts and may be converted into other directions. Hereinafter, the first to third directions are directions indicated by the first to third directions DR1, DR2, and DR3 and are referred to by the same reference numerals, respectively. In addition, in this specification, the phrase "on a plane" may mean when viewed on a plane defined by the first direction DR1 and the second direction DR2.

The electronic device EA according to one or more embodiments may sense a user's input applied from the outside. The user's input includes various types of external inputs, such as a part of the user's body, light, heat, or pressure. The user's input may be provided in various forms, and the electronic device EA may sense the user's input applied to the side or rear surface of the electronic device EA according to the structure of the electronic device EA, and the present disclosure is not limited to any particular embodiments.

As illustrated in FIG. 2, the electronic device EA includes a window WM, a display module DM, and an external case EDC. The window WM and the external case EDC are coupled to each other to form the exterior of the electronic device EA. The external case EDC, the display module DM, and the window WM may be sequentially stacked along the third direction DR3.

The window WM may include an optically transparent material. The window WM may include an insulating panel. For example, the window WM may be made of glass, plastic, or a combination thereof.

As described above, the front surface FS of the window WM defines the front surface of the electronic device EA.

The window WM may include a bezel region and a transmission region. The transmission region may be an optically transparent region. For example, the transmission region may have a visible light transmittance of about 90% or more.

The bezel region may have a relatively low light transmittance compared to the transmission region. The bezel region defines the shape of the transmission region. The bezel region is adjacent to the transmission region and may surround the transmission region. The bezel region may have a color (e.g., a predetermined color). The bezel region may overlap a non-display region DP-NDA of a display panel DP, which will be described later. The bezel region may cover the non-display region DP-NDA of the display panel DP and block the non-display region DP-NDA from being viewed from the outside. Meanwhile, this is described as an example, and in the window WM according to one or more embodiments, the bezel region may be omitted.

The display module DM may include at least a display panel DP. Although FIG. 2 illustrates only the display panel DP in the stacked structure of the display module DM, the display module DM may further include a plurality of components arranged above and below the display panel DP. A detailed description of the stacked structure of the display module DM will be described later.

The display panel DP has a display region DP-DA and a non-display region DP-NDA corresponding to a display region DA (see FIG. 1) and a non-display region NDA (see FIG. 1) of the electronic device EA. In this specification, region "corresponding to" another region means that the regions overlap each other, but the expression is not limited to the regions having a same area. The display module DM may include a driving chip DIC located on the non-display region DP-NDA. The display module DM may further include a printed circuit board PCB coupled to the non-display region DP-NDA. The printed circuit board PCB may be electrically connected to pads located in the non-display region DP-NDA of the display panel DP through an anisotropic conductive adhesive layer.

The driving chip DIC may include driving elements for driving pixels of the display panel DP, for example, a data driving circuit. Although FIG. 2 illustrates a structure in which the driving chip DIC is mounted on the display panel DP, embodiments of the present disclosure are not limited thereto. For example, the driving chip DIC may be mounted on the printed circuit board PCB.

The external case EDC may accommodate the display module DM and may be coupled to the window WM. The external case EDC may protect components accommodated within the external case EDC, such as the display module DM.

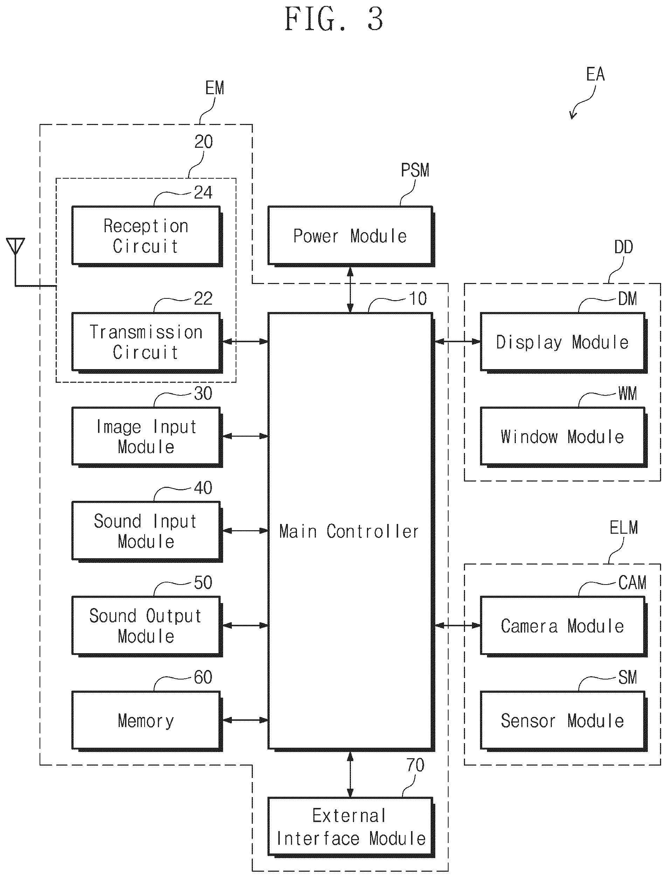

FIG. 3 is a block diagram of the electronic device according to one or more embodiments. In FIG. 3, components included in the above-described electronic device EA are briefly illustrated through the block diagram.

A display device DD may generate an image and sense an external input. The display device DD may include a window (e.g., window module) WM and a display module DM. The display device DD according to one or more embodiments is a device that displays a moving image and/or a still image. The display device DD may be applied to portable electronic devices such as mobile phones, smartphones, tablet personal computers (PCs), mobile communication terminals, electronic notebooks, electronic books, portable multimedia players (PMPs), navigations, and ultra-mobile PCs (UMPCs). For example, the display device DD may be applied to a display unit of a television, a laptop computer, a monitor, a billboard, or the Internet of Things (IoT) deivce. Alternatively, in one or more embodiments, the display device DD may be applied to a smartwatch, a watch phone, a virtual reality (VR) device, an augmented reality (AR) device, and/or a head-mounted display device (HMD) (e.g., for implementing virtual reality and/or augmented reality).

A control module EM includes at least a main controller 10. The control module EM may include a main controller 10, a wireless communication module 20, an image input module 30, a sound input module 40, a sound output module 50, a memory 60, an external interface module 70, and the like. The modules may be mounted on the circuit board or electrically connected to each other through a flexible circuit board. The control module EM may be electrically connected to a power module PSM.

The main controller 10 controls the overall operation of the electronic device EA. For example, the main controller 10 activates or deactivates the display device DD in accordance with a user input. The main controller 10 may control the image input module 30, the sound input module 40, and the sound output module 50 in accordance with a user input. The main controller 10 may include at least one microprocessor.

The wireless communication module 20 may transmit/receive a wireless signal to/from another terminal by using a Bluetooth^{®} or Wi-Fi^{®} line (Wi-Fi^{®} being a registered trademark of the non-profit Wi-Fi Alliance, and Bluetooth^{®} being a registered trademark of Bluetooth Sig, Inc., Kirkland, WA). The wireless communication module 20 may transmit/receive a voice signal by using a general communication line. The wireless communication module 20 includes a transmission circuit 22, which modulates a signal to be transmitted and transmits the signal, and a reception circuit 24, which demodulates the received signal.

The image input module 30 processes an image signal and converts the image signal into image data that may be displayed on the display device DD. The sound input module 40 receives an external sound signal through a microphone in a recording mode, a voice recognition mode, and the like and converts the external sound signal into electrical voice data. The sound output module 50 converts sound data received from the wireless communication module 20 or sound data stored in the memory 60 and outputs the converted sound data to the outside.

The external interface module 70 may serve as an interface, which is connected to an external charger, a wired/wireless data port, a card socket (e.g., a memory card, a SIM/UIM card), and the like.

An electronic module ELM may be an electronic component that outputs or receives an optical signal. The electronic module ELM may be located below the display device DD. In the display panel DP of the display device DD, a signal transmission region having a higher light transmittance compared to other regions is defined, and the electronic module ELM transmits or receives an optical signal through a partial region of the electronic device EA, which corresponds to the signal transmission region. The electronic module ELM may include a camera module CAM. The camera module CAM may receive a natural light signal and capture an external image. The electronic module ELM may also include a sensor module SM, such as a proximity sensor or an ultraviolet light-emitting sensor. The sensor module SM may recognize a part of a user's body (e.g. fingerprint, iris, or face) or measure the distance between an object and a mobile phone.

The power module PSM supplies power suitable for the overall operation of the electronic device EA. The power module PSM may include a typical battery device.

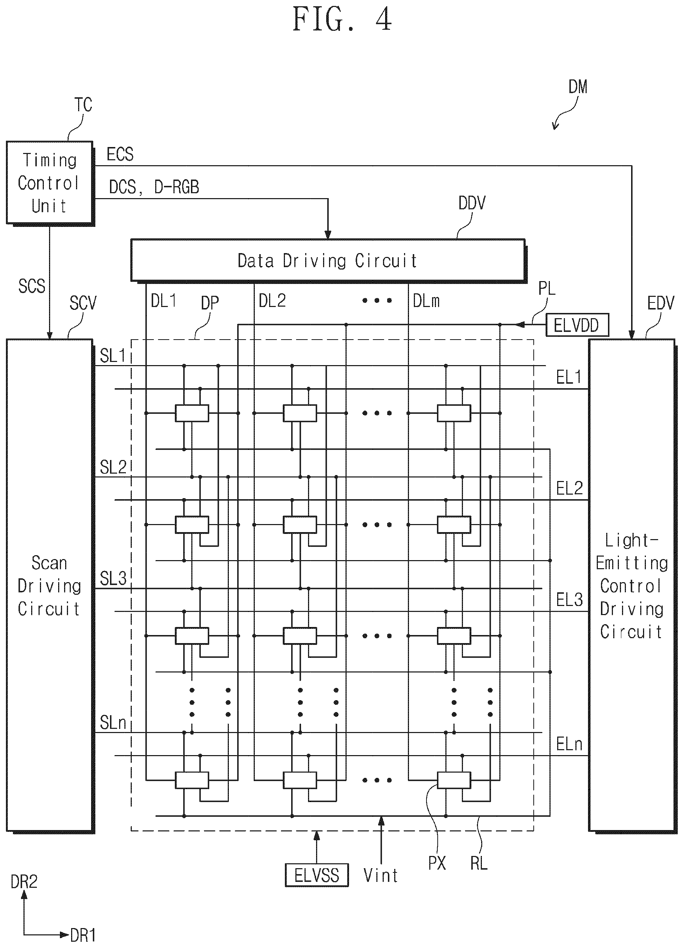

FIG. 4 is a block diagram of a display module according to one or more embodiments. The display module DM may include at least one semiconductor. The display module may include a timing controller (e.g., timing control unit) TC, a scan driver (e.g., scan-driving circuit) SCV, a data driver (e.g., data-driving circuit) DDV, a light-emission controller (e.g., light-emission-control-driving circuit EDV), and a display panel DP. The display panel DP displays an image according to an electrical signal.

In FIG. 4 the display panel DP is described in one implementation as an organic light-emitting display panel. Meanwhile, this is described as an example, and the display panel DP may include various embodiments.

In one or more embodiments, the timing controller TC receives input image signals, converts the data format of the input image signals so as to meet the interface specifications with thedata driver DDV and generates image data D-RGB. The timing controller TC outputs image data D-RGB and various control signals DCS, SCS, and ECS.

The scan driver SCV receives a scan control signal SCS from the timing controller TC. The scan control signal SCS may include a vertical start signal for starting the operation of the scan driver SCV, a clock signal for determining the output timing of signals, and the like.

The scan driver SCV generates a plurality of scan signals, and sequentially outputs the scan signals to a plurality of scan lines SL1 to SLn.

The light-emitting control driving circuit EDV receives a light-emitting control signal ECS from the timing controller TC. The light-emitting control driving circuit EDV generates a plurality of light-emitting control signals in response to the light-emitting control signal ECS, and outputs the light-emitting control signals to a plurality of light-emitting lines EL1 to ELn.

It is illustrated that the scan signals and the light-emitting control signals are separately output from the scan driver SCV and the light-emitting control driving circuit EDV, respectively, but without being limited thereto, the light-emitting control driving circuit EDV may be omitted, and the scan signals and the light-emitting control signals may be output from the scan driver SCV.

The data driver DDV receives a data control signal DCS and image data D-RGB from the timing controller TC. The data driver DDV converts the image data D-RGB into data signals and outputs the data signals to data lines DL1 to DLm. The data signals are analog voltages corresponding to the grayscale values of the image data D-RGB.

The display panel DP includes scan lines SL1 to SLn, light-emitting lines EL1 to ELn, data lines DL1 to DLm, and pixels PX. The scan lines SL1 to SLn extend in the first direction DR1 and are aligned with each other in the second direction DR2 crossing the first direction DR1.

Each of the plurality of light-emitting lines EL1 to ELn may be arranged in parallel with a corresponding scan line among the scan lines SL1 to SLn. The data lines DL1 to DLm are insulated from and cross the scan lines SL1 to SLn.

Each of the plurality of pixels PX is connected to a corresponding scan line among the scan lines SL1 to SLn, a corresponding light-emitting line among the light-emitting lines EL1 to ELn, and a corresponding data line among the data lines DL1 to DLm.

Each of the pixels PX receives a first power voltage ELVDD, and a second power voltage ELVSS having a lower level than the first power voltage ELVDD. Each of the pixels PX is connected to a driving power line PL to which the first power voltage ELVDD is applied. Each of the pixels PX is connected to an initialization line RL that receives an initialization voltage Vint.

Each of the pixels PX may be electrically connected to three scan lines. As illustrated in FIG. 4, pixels in a second pixel row may be connected to first to third scan lines SL1 to SL3.

Meanwhile, the display panel DP may further include a plurality of dummy scan lines. The display panel DP may further include a dummy scan line connected to the pixels PX of a first pixel row and a dummy scan line connected to the pixels PX of an n-th pixel row. In addition, pixels (hereinafter referred to as pixels of a pixel column) connected to any one of the data lines DL1 to DLm may be connected to each other. Two adjacent pixels among the pixels in the pixel column may be electrically connected to each other. However, this is described as an example, and the connection relationship between the pixels PX according to one or more embodiments may be designed in various ways, and is not limited to any particular embodiments.

In one or more embodiments, each of the pixels PX includes a light-emitting element and a pixel driver (e.g., pixel-driving circuit) that controls the light emission of the light-emitting element. The pixel driver may include a thin film transistor and a capacitor.

At least any one of the scan driver SCV, the light-emitting control driving circuit EDV, or the data driver DDV may include thin film transistors provided through the same process as the pixel driving circuit. For example, the scan driver SCV, the light-emitting control driving circuit EDV, and the data driver DDV may all be provided by being mounted on the display panel DP. Alternatively, two of the scan driver SCV, the light-emitting control driving circuit EDV, and the data driver DDV may be mounted on the display panel DP, and the remaining one may be provided on the printed circuit board PCB (see FIG. 2), or may be provided as a separate driving chip DIC (see FIG. 2) independent from the display panel DP and be connected to the display panel DP.

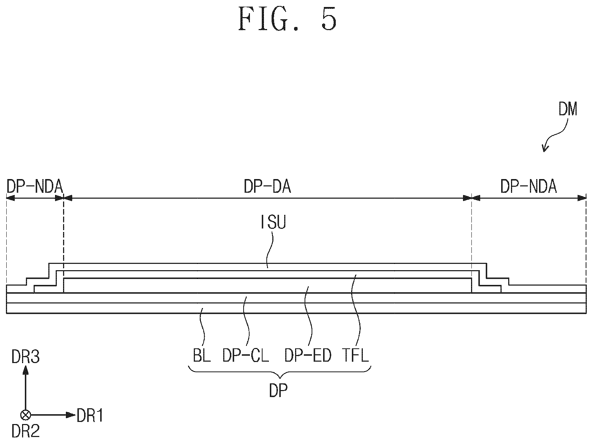

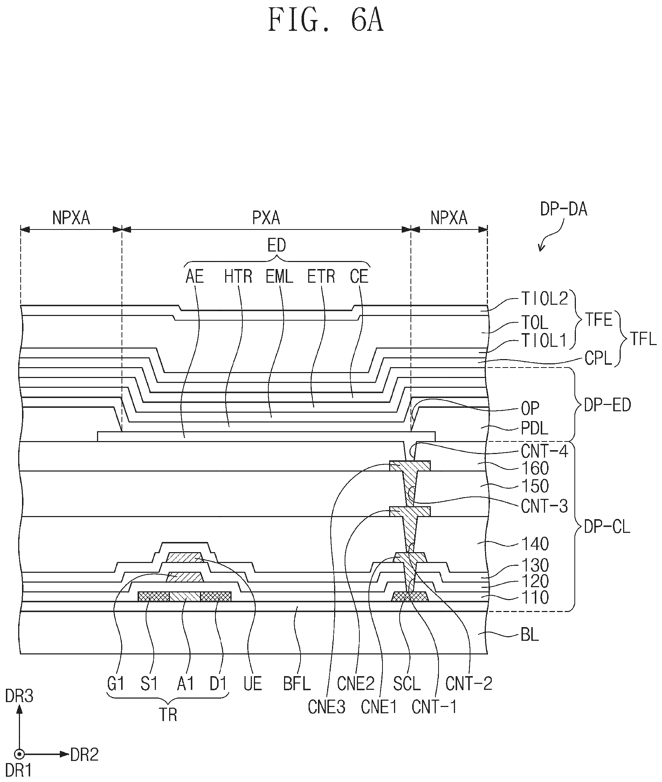

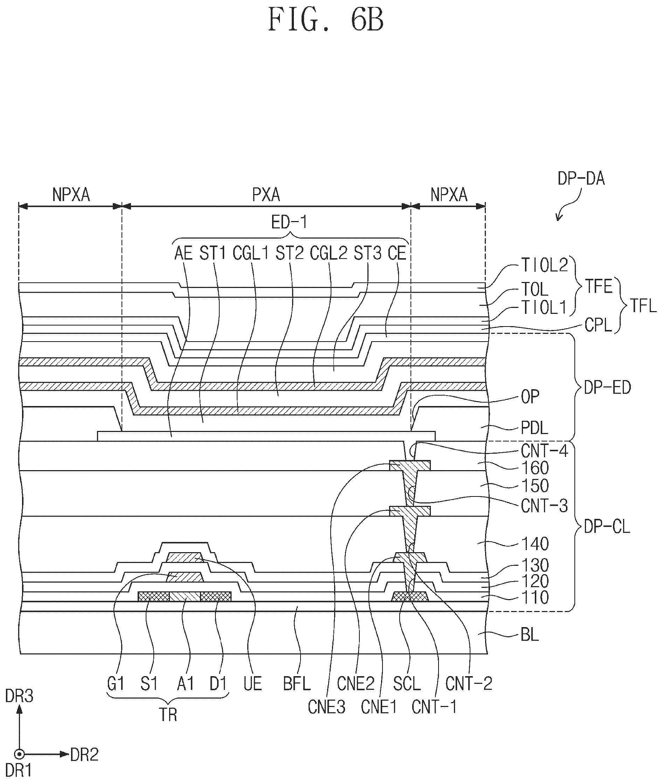

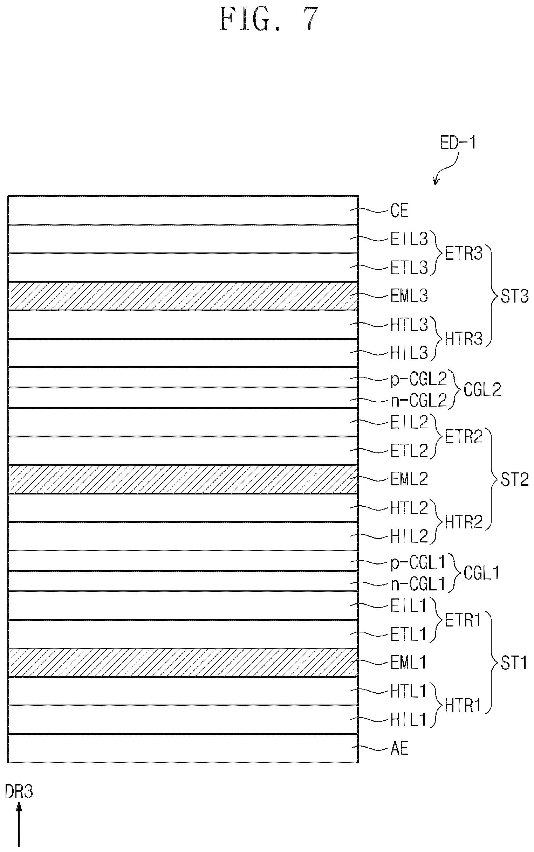

FIG. 5 is a cross-sectional view of the display module according to one or more embodiments. FIG. 6A is a cross-sectional view of a portion of a display panel included in the display module according to one or more embodiments. FIG. 6B is a cross-sectional view of a portion of a display panel according to one or more other embodiments. FIG. 7 is a cross-sectional view of a light-emitting element according to one or more embodiments. Each of FIGS. 6A and 6B illustrates a light-emitting element and a transistor included in one pixel included in the display panel according to one or more embodiments.

Referring to FIG. 5, the display module DM may include a display panel DP and an input sensor (e.g., an input-sensing unit) ISU. The display panel DP may be configured to substantially generate an image IM (see FIG. 1). The image IM (see FIG. 1) generated by the display panel DP may be viewed by a user from the outside through the display region DA (see FIG. 1).

The display panel DP may be a light-emitting display panel in some implementations and is not limited thereto. For example, the display panel DP may be an organic light-emitting display panel or an inorganic light-emitting display panel. The organic light-emitting display panel may be a display panel in which a light-emitting layer includes an organic light-emitting material. The inorganic light-emitting display panel may be a display panel in which a light-emitting layer includes quantum dots, quantum rods, or micro LEDs. Hereinafter, the display panel DP will be described as an organic light-emitting display panel.

The input sensor ISU may be located on the display panel DP (as used herein, "located on" may mean "above"). The input sensor ISU may sense an external input applied from the outside. The external input may include various types of inputs provided from the outside of the electronic device EA (see FIG. 1). The external input may be provided in various forms. For example, the external input may include not only a touch by a part of a user's body, such as a user's hand, but also an external input (e.g., hovering) applied at a place close to or adjacent to the electronic device EA at a distance (e.g., a predetermined distance). In addition, the external input may have various forms, such as force, pressure, and light, and is not limited to any one embodiment.

The input sensor ISU may be formed on the display panel DP through a continuous process. In this case, the input sensor ISU may be located directly on the display panel DP. As used herein, the expression "Component A is located directly on component B" means that no adhesive layer is located between component A and component B. For example, an adhesive layer may not be located between the input sensor ISU and the display panel DP.

The display panel DP may include a base layer BL, a circuit layer DP-CL located on the base layer BL, a light-emitting element layer DP-ED, and an upper insulating layer TFL.

The base layer BL may provide a base surface on which the circuit layer DP-CL, the light-emitting element layer DP-ED, and the upper insulating layer TFL are arranged. The base layer BL may be a rigid substrate or a flexible substrate capable of being bent, folded, or rolled. The base layer BL may be a glass substrate, a metal substrate, or a polymer substrate. However, embodiments of the present disclosure are not limited thereto, and the base layer BL may include an inorganic layer, an organic layer, or a composite material layer.

The base layer BL may have a multi-layered structure. For example, the base layer BL may include a first synthetic resin layer, a multi-layered or single-layered inorganic layer, and a second synthetic resin layer located on the multi-layered or single-layered inorganic layer. Each of the first and second synthetic resin layers may include a polyimide-based resin, but is not limited thereto.

The circuit layer DP-CL may be located on the base layer BL. The circuit layer DP-CL may include a plurality of insulating layers, a plurality of conductive layers, and a semiconductor layer. The plurality of conductive layers of the circuit layer DP-CL may constitute signal lines or a control circuit of a pixel.

The light-emitting element layer DP-ED may be located on the circuit layer DP-CL. The light-emitting element layer DP-ED may include light-emitting elements. The light-emitting element layer DP-ED may include, for example, organic light-emitting elements. However, this is an example, and the light-emitting element layer DP-ED according to one or more embodiments may include inorganic light-emitting elements, organic-inorganic light-emitting elements, or a liquid crystal layer. The light-emitting element layer DP-ED may further include a pixel-defining structure. A pixel opening, in which each light-emitting element is located, may be defined in the pixel-defining structure.

The upper insulating layer TFL may include a capping layer and an encapsulation layer, which will be described later. The encapsulation layer may include an organic layer and a plurality of inorganic layers, which seal the organic layer.

The upper insulating layer TFL may be located on the light-emitting element layer DP-ED to protect the light-emitting element layer DP-ED from moisture, oxygen, and foreign substances, such as dust particles. The upper insulating layer TFL may seal the light-emitting element layer DP-ED to block moisture and oxygen from entering the light-emitting element layer DP-ED. The upper insulating layer TFL may include at least one inorganic layer. The upper insulating layer TFL may include an organic layer and a plurality of inorganic layers, which seal the organic layer. The upper insulating layer TFL may include a structure in which an inorganic layer, an organic layer, and an inorganic layer are sequentially stacked.

The input sensor ISU is located on the upper insulating layer TFL. The input sensor ISU may be formed on the upper insulating layer TFL through a continuous process. The input sensor ISU may be located directly on the display panel DP. That is, a separate adhesive member may not be located between the input sensor ISU and the display panel DP. The input sensor ISU may be arranged to be in contact with the inorganic layer located at the uppermost portion of the upper insulating layer TFL.

Although not separately illustrated, the display module DM according to one or more embodiments may further include a protection member located on the lower surface of the display panel DP and an anti-reflection member located on the upper surface of the input sensor ISU. The anti-reflection member may reduce the reflectance of external light. The anti-reflection member may be located directly on the input sensor ISU through a continuous process.

The anti-reflection member may include a light-blocking pattern that overlaps a reflective structure located below the anti-reflection member. The anti-reflection member may further include a color filter. The color filter may be located between light-blocking patterns and include a first color filter, a second color filter, and a third color filter corresponding to a first color pixel, a second color pixel, and a third color pixel.

As illustrated in FIG. 5, the display panel DP may be divided into a display region DP-DA and a non-display region DP-NDA on a plane. The display region DP-DA of the display panel DP may be a region on which an image is displayed, and the non-display region DP-NDA may be a region on which a driving circuit, a driving line, or the like is located. A light-emitting element of each of a plurality of pixels may be located in the display region DP-DA. The display region DP-DA may overlap at least a portion of the transmission region of the window WM (see FIG. 2), and the non-display region DP-NDA may be covered by the bezel region of the window WM. The display region DP-DA and non-display region DP-NDA of the display panel DP may respectively correspond to the display region DA and non-display region NDA of the electronic device EA illustrated in FIG. 1.

Referring to FIGS. 5 and 6A, in the display panel DP according to one or more embodiments, a circuit layer DP-CL, a light-emitting element layer DP-ED, and an upper insulating layer TFL may be sequentially arranged on the base layer BL. The configuration of the circuit layer DP-CL, the light-emitting element layer DP-ED, and the upper insulating layer TFL will be described in detail through FIG. 6A.

The circuit layer DP-CL includes at least one insulating layer and a circuit element. The circuit element includes a signal line, a pixel driving circuit, and the like. The circuit layer DP-CL may be provided through a process of forming an insulating layer, a semiconductor layer, and a conductive layer by coating, deposition, or the like and then a process of patterning the insulating layer, the semiconductor layer, and the conductive layer by a photolithography method.

The buffer layer BFL may include at least one stacked inorganic layer. A semiconductor pattern is located on the buffer layer BFL. The buffer layer BFL improves the bonding strength between the base layer BL and the semiconductor pattern.

The semiconductor pattern may include polysilicon. Without being limited thereto, however, the semiconductor pattern may also include amorphous silicon or metal oxide. FIGS. 6A and 6B illustrate only a portion of the semiconductor pattern, and the semiconductor pattern may be further arranged in another region of a pixel on a plane. The semiconductor pattern may be arranged in a corresponding rule or pattern across pixels.

Semiconductor patterns have different electrical properties depending on doping, such as a presence of a dopant, or a doping concentration. The semiconductor pattern may include a first region A1 having a low doping concentration and conductivity and second regions S1 and D1 having a relatively high doping concentration and conductivity. One second region S1 may be located at one side of the first region A1, and the other second region D1 may be located at the other side of the first region A1. The second regions S1 and D1 may be doped with an N-type dopant or a P-type dopant. A P-type transistor includes a doped region doped with a P-type dopant. The first region A1 may be a non-doped region or may be doped with a lower concentration than that of the second regions S1 and D1.

The second regions S1 and D1 substantially serve as an electrode or a signal line. One second region S1 may correspond to a source of a transistor TR, and one second region D1 may be a drain. FIGS. 6A and 6B illustrate a portion of a connection signal line SCL from the semiconductor pattern. In one or more embodiments, the connection signal line SCL may be connected to the drain of the transistor TR on a plane.

A first insulating layer 110 may be located on the buffer layer BFL. The first insulating layer 110 overlaps a plurality of pixels in common and covers the semiconductor pattern. The first insulating layer 110 may be an inorganic layer and/or an organic layer and have a single-layered or multi-layered structure. The first insulating layer 110 may include at least one of aluminum oxide, titanium oxide, silicon oxide, silicon oxynitride, zirconium oxide, or hafnium oxide. An insulating layer of the circuit layer DP-CL to be described later as well as the first insulating layer 110 may be an inorganic layer and/or an organic layer and have a single-layered or multi-layered structure.

A gate G1 is located on the first insulating layer 110. The gate G1 may be a portion of a metal pattern. The gate G1 overlaps the first region A1. In a process of doping the semiconductor pattern, the gate G1 may function as a mask.

A second insulating layer 120 may be located on the first insulating layer 110, and may cover the gate G1. The second insulating layer 120 commonly overlaps the pixels. An upper electrode UE may be located on the second insulating layer 120. The upper electrode UE may overlap the gate G1. The upper electrode UE may include a multi-layered metal layer. In one or more embodiments, the upper electrode UE may be omitted.

A third insulating layer 130 may be located on the second insulating layer 120, and may cover the upper electrode UE. A first connection electrode CNE1 may be located on the third insulating layer 130. The first connection electrode CNE1 may be connected to the connection signal line SCL through a contact hole CNT-1 passing through the first to third insulating layers 110 to 130.

A fourth insulating layer 140 may be located on the third insulating layer 130, and a fifth insulating layer 150 may be located on the fourth insulating layer 140. The fourth insulating layer 140 may be an organic layer. A second connection electrode CNE2 may be located on the fourth insulating layer 140. The second connection electrode CNE2 may be connected to the first connection electrode CNE1 through a contact hole CNT-2 passing through the fourth insulating layer 140.

The fifth insulating layer 150 may be located on the fourth insulating layer 140 and be an organic layer. A third connection electrode CNE3 may be located on the fifth insulating layer 150. The third connection electrode CNE3 may be connected to the second connection electrode CNE2 through a contact hole CNT-3 passing through the fifth insulating layer 150.

A sixth insulating layer 160 may be located on the fifth insulating layer 150, and may cover the third connection electrode CNE3. The sixth insulating layer 160 may be an organic layer.

A light-emitting element ED may be located on the sixth insulating layer 160. The light-emitting element ED may include a first electrode AE, a hole transport region HTR, a light-emitting layer EML, an electron transport region ETR, and a second electrode CE, which are sequentially stacked.

The first electrode AE of the light-emitting element ED may be located on the sixth insulating layer 160. The first electrode AE is connected to the third connection electrode CNE3 through a contact hole CNT-4 passing through the sixth insulating layer 160. A pixel opening OP is defined in a pixel-defining film PDL, and the pixel-defining film PDL exposes at least a portion of the first electrode AE. The pixel-defining film PDL may be an organic layer.

As illustrated in FIG. 6A, the display region DP-DA may include a pixel region PXA, and a non-pixel region NPXA adjacent to the pixel region PXA. The non-pixel region NPXA may surround the pixel region PXA. The pixel region PXA corresponds to a partial region of the first electrode AE exposed by the pixel opening OP.

The hole transport region HTR may be commonly located in the pixel region PXA and the non-pixel region NPXA. The hole transport region HTR may include a hole transport layer and may further include a hole injection layer. The light-emitting layer EML is located on the hole transport region HTR.

An electron transport region ETR may be located on the light-emitting layer EML. The electron transport region ETR may include an electron transport layer and may further include an electron injection layer. The hole transport region HTR, the light-emitting layer EML, and the electron transport region ETR may be commonly provided in a plurality of pixels by using an open mask. Without being limited thereto, however, at least one of the hole transport region HTR, the light-emitting layer EML, or the electron transport region ETR may be provided by being patterned through a mask. For example, the light-emitting layer EML may be located in a region corresponding to the pixel opening OP. That is, the light-emitting layer EML may be provided separately in each pixel.

The second electrode CE may be located on the electron transport region ETR. The second electrode CE may have an integral shape and be commonly located in a plurality of pixels.

The upper insulating layer TFL may be located on the light-emitting element layer DP-ED and include a plurality of thin films. According to one or more embodiments, the upper insulating layer TFL may include a capping layer CPL and an encapsulation layer TFE located on the capping layer CPL. The capping layer CPL is located on and in contact with the second electrode CE. The capping layer CPL may include an organic material. The capping layer CPL may have a refractive index of about 1.6 or more in a wavelength range of about 550 nm to about 660 nm.

The encapsulation layer TFE may include a first inorganic encapsulation layer TIOL1, an organic encapsulation layer TOL located on the first inorganic encapsulation layer TIOL1, and a second inorganic encapsulation layer TIOL2 located on the organic encapsulation layer TOL. The first inorganic encapsulation layer TIOL1 and the second inorganic encapsulation layer TIOL2 protect the light-emitting element layer DP-ED from moisture/oxygen, and the organic encapsulation layer TOL protects the light-emitting element layer DP-ED from foreign substances, such as dust particles.

FIG. 6B illustrates a portion of a display panel including a light-emitting element ED-1 different from the one or more embodiments corresponding to FIG. 6A. FIG. 7 briefly illustrates the stacked structure of the light-emitting element ED-1 included in FIG. 6B. Hereinafter, in describing the display panel of one or more other embodiments through FIG. 6B, the same reference numerals will be assigned to the same components as those previously described in FIG. 6A and the detailed descriptions thereof will be omitted.

Referring to FIGS. 6B and 7, the light-emitting element ED-1 included in the display panel according to one or more embodiments may include a plurality of light-emitting stacks ST1, ST2, and ST3 and charge generation layers CGL1 and CGL2 located between the plurality of light-emitting stacks ST1, ST2, and ST3. The light-emitting element ED-1 according to one or more embodiments may include a first electrode AE, a first light-emitting stack ST1, a first charge generation layer CGL1, a second light-emitting stack ST2, a second charge generation layer CGL2, a third light-emitting stack ST3, and a second electrode CE. Meanwhile, FIG. 7 illustrates that the light-emitting element ED-1 includes three light-emitting stacks ST1, ST2, and ST3 and two charge generation layers CGL1 and CGL2 located between them. Without being limited thereto, the light-emitting element ED-1 may include two light-emitting stacks, or may include four or more light-emitting stacks.

Each of the plurality of light-emitting stacks ST1, ST2, and ST3 may include a light-emitting layer EML (see FIG. 6A), and a hole transport region HTR (see FIG. 6A) and an electron transport region ETR (see FIG. 6A) with the light-emitting layer EML (see FIG. 6A) interposed therebetween. In one or more embodiments, the first light-emitting stack ST1 may include a first light-emitting layer EML1, the second light-emitting stack ST2 may include a second light-emitting layer EML2, and the third light-emitting stack ST3 may include a third light-emitting layer EML3. That is, the light-emitting element ED-1 may be a light-emitting element with a tandem structure including a plurality of light-emitting stacks, which respectively include light-emitting layers.

In the one or more embodiments corresponding to FIG. 6B, light emitted from each of the plurality of light-emitting stacks ST1, ST2, and ST3 may all have a same wavelength. For example, light emitted from each of the plurality of light-emitting stacks ST1, ST2, and ST3 may be blue light. However, embodiments of the present disclosure are not limited thereto, and the wavelength ranges of light emitted from the plurality of light-emitting stacks ST1, ST2, and ST3 may be different from each other. For example, at least one of the plurality of light-emitting stacks ST1, ST2, and ST3 may emit blue light, and the remaining stacks may emit green light or red light. The light-emitting element ED-1 including the plurality of light-emitting stacks ST1, ST2, and ST3 that emit light of different wavelength ranges may emit white light.

The charge generation layers CGL1 and CGL2 may be located between the neighboring light-emitting stacks ST1, ST2, and ST3.

Referring to FIG. 7, in one or more embodiments, the light-emitting element ED-1 may emit light from the first electrode AE toward the second electrode CE. It is illustrated that, based on the direction in which light is emitted, the light-emitting element ED-1 has a structure in which hole transport regions HTR1, HTR2, and HTR3 are located below the light-emitting layers EML1, EML2, and EML3 of the stacks and electron transport regions ETR1, ETR2, and ETR3 are located on the light-emitting layers EML1, EML2, and EML3 of the stacks. Without being limited thereto, however, based on the direction in which light is emitted, the light-emitting element ED-1 according to one or mor embodiments may have an inverted element structure in which the electron transport regions ETR1, ETR2, and ETR3 are located below the light-emitting layers EML1, EML2, and EML3 of the stacks and the hole transport regions HTR1, HTR2, and HTR3 are located on the light-emitting layers EML1, EML2, and EML3 of the stacks.

The light-emitting element ED according to one or more embodiments may include charge generation layers CGL1 and CGL2 located between the plurality of stacks ST1, ST2, and ST3. The light-emitting element ED according to one or more embodiments may include a first charge generation layer CGL1 located between the first light-emitting stack ST1 and the second light-emitting stack ST2 and a second charge generation layer CGL2 located between the second light-emitting stack ST2 and the third light-emitting stack ST3.

When a voltage is applied, the charge generation layers CGL1 and CGL2 may generate charges (electrons and holes) by forming a complex through an oxidation-reduction reaction. Hereafter, the charge generation layers CGL1 and CGL2 may respectively provide the generated charges to the stacks ST1, ST2, and ST3 adjacent thereto. The charge generation layers CGL1 and CGL2 may double the efficiency of a current generated in each of the stacks ST1, ST2, and ST3 adjacent thereto and play a role in controlling the balance of charges between the stacks ST1, ST2, and ST3 adjacent thereto.

Each of the charge generation layers CGL1 and CGL2 may have a layer structure in which an n-type charge generation layer n-CGL1 or n-CGL2 and a p-type charge generation layer p-CGL1 or p-CGL2 are bonded to each other. The first charge generation layer CGL1 may have a layer structure in which a first n-type charge generation layer n-CGL1 and a first p-type charge generation layer p-CGL1 are bonded to each other. The second charge generation layer CGL2 may have a layer structure in which a second n-type charge generation layer n-CGL2 and a second p-type charge generation layer p-CGL2 are bonded to each other.

The n-type charge generation layers n-CGL1 and n-CGL2 may provide electrons to adjacent stacks. The n-type charge generation layers n-CGL1 and n-CGL2 may be layers in which a base material is doped with an n-dopant. The p-type charge generation layers p-CGL1 and p-CGL2 may provide holes to adjacent stacks. In one or more embodiments, a buffer layer may be further arranged between the n-type charge generation layers n-CGL1 and n-CGL2 and the p-type charge generation layers p-CGL1 and p-CGL2.

Each of the charge generation layers CGL1 and CGL2 may include an n-type arylamine-based material or a p-type metal oxide. For example, each of the charge generation layers CGL1 and CGL2 may include a charge generation compound made of an arylamine-based organic compound, metal, metal oxide, carbide, fluoride, or a mixture thereof.

For example, the arylamine-based organic compound may be α-NPD, 2-TNATA, TDATA, MTDATA, sprio-TAD, or sprio-NPB. For example, the metal may be cesium (Cs), molybdenum (Mo), vanadium (V), titanium (Ti), tungsten (W), barium (Ba), or lithium (Li). In addition, for example, the oxides, carbides, and fluorides of the metal may be Re₂O₇, MoO₃, V₂O₅, WO₃, TiO₂, Cs₂CO₃, BaF₂, LiF, or CsF.

In the light-emitting element ED according to one or more embodiments, the first light-emitting stack ST1, the second light-emitting stack ST2, and the third light-emitting stack ST3 respectively include light-emitting layers EML1, EML2, and EML3 that emit light of respective wavelengths. For example, the light-emitting layers EML1, EML2, and EML3 may emit light of a first wavelength, and the light of the first wavelength may be light in a blue wavelength range. In one or more embodiments, the light of the first wavelength may be light in a wavelength range of about 410 nm to about 480 nm. Each of the light-emitting layers EML1, EML2, and EML3 may include a host material and a blue light-emitting dopant. The dopant included in each of the light-emitting layers EML1, EML2, and EML3 may be a blue fluorescent dopant. Each of the light-emitting layers EML1, EML2, and EML3 may include a same host material and a same dopant material. Meanwhile, at least some of the light-emitting layers EML1, EML2, and EML3 may emit light of a second wavelength or light of a third wavelength in addition to the light of the first wavelength. The light of the second wavelength may be light in a green wavelength range. In one or more embodiments, the light of the second wavelength may be light in a wavelength range of about 500 nm to about 600 nm. The light of the third wavelength may be light in a red wavelength range. In one or more embodiments, the light of the third wavelength may be light in a wavelength range of about 620 nm to about 700 nm.

The first light-emitting stack ST1 may further include a first hole transport region HTR1 that transports holes, which are provided from the first electrode AE, to the first light-emitting layer EML1 and a first electron transport region ETR1 that transports electrons, which are generated from the first charge generation layer CGL1, to the first light-emitting layer EML1.

The first hole transport region HTR1 may include a first hole injection layer HIL1 located on the first electrode AE and a first hole transport layer HTL1 located on the first hole injection layer HIL1. The first hole transport layer HTL1 may be in contact with the lower surface of the first light-emitting layer EML1. Without being limited thereto, however, the first hole transport region HTR1 may further include a first hole-side additional layer located on the first hole transport layer HTL1. The first hole-side additional layer may include at least one of a hole buffer layer, a light-emitting auxiliary layer, or an electron-blocking layer. The hole buffer layer may increase light-emitting efficiency by compensating for a resonance distance depending on the wavelength of light emitted from the light-emitting layer. The electron-blocking layer may serve to reduce or prevent electrons from being injected from the electron transport region to the hole transport region.

The first electron transport region ETR1 may include a first electron transport layer ETL1 located on the first light-emitting layer EML1. The first electron transport layer ETL1 may be located between the first light-emitting layer EML1 and the first charge generation layer CGL1 and be in contact with the first light-emitting layer EML1. The first electron transport region ETR1 may further include a first electron injection layer EIL1 located between the first electron transport layer ETL1 and the first charge generation layer CGL1. The first electron transport region ETR1 may further include a first electron-side additional layer located between the first electron transport layer ETL1 and the first light-emitting layer EML1. The first electron-side additional layer may include at least one of an electron buffer layer or a hole blocking layer.

The second light-emitting stack ST2 may further include a second hole transport region HTR2 that transports holes, which are generated from the first charge generation layer CGL1, to the second light-emitting layer EML2 and a second electron transport region ETR2 that transports electrons, which are provided from the second charge generation layer CGL2, to the second light-emitting layer EML2.

The second hole transport region HTR2 may include a second hole injection layer HIL2 located on the first charge generation layer CGL1 and a second hole transport layer HTL2 located on the second hole injection layer HIL2. The second hole transport layer HTL2 may be in contact with the lower surface of the second light-emitting layer EML2. Without being limited thereto, however, the second hole transport region HTR2 may further include a second hole-side additional layer located on the second hole transport layer HTL2. The second hole-side additional layer may include at least one of a hole buffer layer, a light-emitting auxiliary layer, or an electron-blocking layer.

The second electron transport region ETR2 may include a second electron transport layer ETL2 located on the second light-emitting layer EML2. The second electron transport layer ETL2 may be located between the second light-emitting layer EML2 and the second charge generation layer CGL2 and be in contact with the second light-emitting layer EML2. The second electron transport region ETR2 may further include a second electron injection layer EIL2 located between the second electron transport layer ETL2 and the second charge generation layer CGL2. The second electron transport region ETR2 may further include a second electron-side additional layer located between the second electron transport layer ETL2 and the second light-emitting layer EML2. The second electron-side additional layer may include at least one of an electron buffer layer or a hole blocking layer.

The third light-emitting stack ST3 may further include a third hole transport region HTR3 that transports holes, which are generated from the second charge generation layer CGL2, to the third light-emitting layer EML3 and a third electron transport region ETR3 that transports electrons, which are provided from the second electrode CE, to the third light-emitting layer EML3.

The third hole transport region HTR3 may include a third hole injection layer HIL3 located on the second charge generation layer CGL2 and a third hole transport layer HTL3 located on the third hole injection layer HIL3. The third hole transport layer HTL3 may be in contact with the lower surface of the third light-emitting layer EML3. Without being limited thereto, however, the third hole transport region HTR3 may further include a third hole-side additional layer located on the third hole transport layer HTL3. The third hole-side additional layer may include at least one of a hole buffer layer, a light-emitting auxiliary layer, or an electron-blocking layer.

The third electron transport region ETR3 may include a third electron transport layer ETL3 located on the third light-emitting layer EML3 and a third electron injection layer EIL3 located on the third electron transport layer ETL3. The third electron transport layer ETL3 may be in contact with the third light-emitting layer EML3. Without being limited thereto, however, the third electron transport region ETR3 may further include a third electron-side additional layer located between the third electron transport layer ETL3 and the third light-emitting layer EML3. The third electron-side additional layer may include at least one of an electron buffer layer or a hole blocking layer.

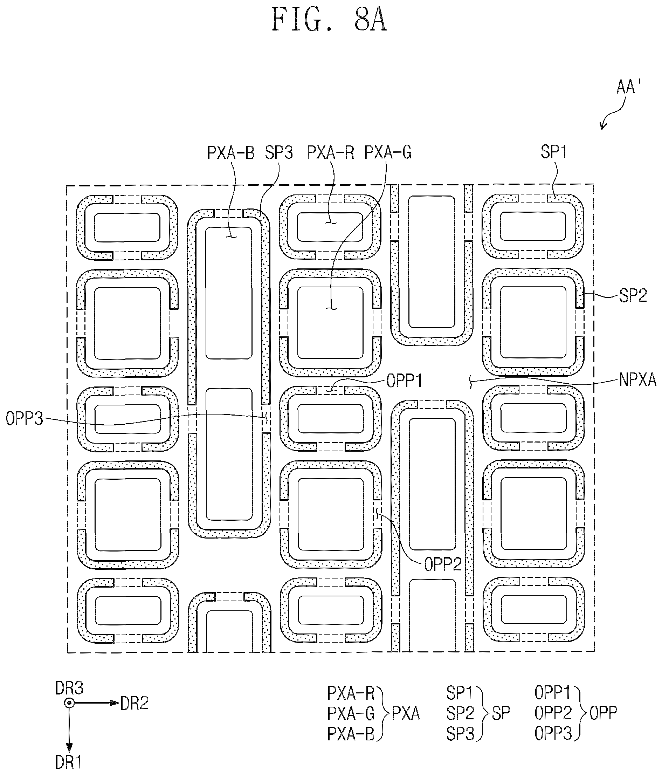

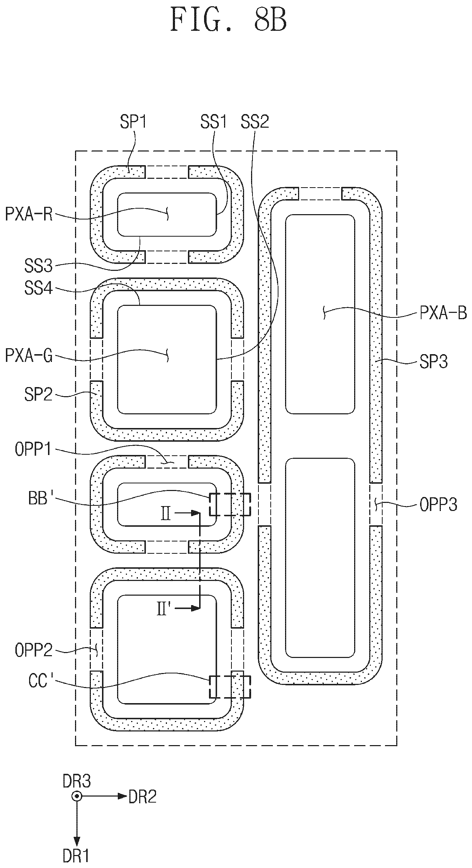

FIGS. 8A and 8B are enlarged plan views of a portion of a display module according to one or more embodiments. FIG. 8A illustrates an enlarged view of an arrangement of a plurality of pixel regions and a configuration of a valley pattern SP defined adjacent thereto in a region AA' illustrated in FIG. 2. Meanwhile, FIG. 8B illustrates an enlarged view of a planar arrangement of two first pixel regions PXA-R, two second pixel regions PXA-G, and two third pixel regions PXA-B among the plurality of pixel regions illustrated in FIG. 8A and a valley pattern SP defined adjacent thereto.

Referring to FIGS. 2, 8A, and 8B, in the display panel DP according to one or more embodiments, the display region DP-DA may include a plurality of pixel regions PXA and a non-pixel region NPXA surrounding the plurality of pixel regions PXA. The plurality of pixel regions PXA may include a first pixel region PXA-R, a second pixel region PXA-G, and a third pixel region PXA-B. The first pixel region PXA-R, the second pixel region PXA-G, and the third pixel region PXA-B may display light of different wavelengths. The first pixel region PXA-R may display a first light having a red light wavelength, the second pixel region PXA-G may display a second light having a green light wavelength, and the third pixel region PXA-B may display a third light having a blue light wavelength.

Meanwhile, each of the plurality of pixel regions PXA may be a region divided by the above-described pixel-defining film PDL (see FIG. 6B). The non-pixel region NPXA is a region between neighboring pixel regions PXA and may be a region corresponding to the pixel-defining film PDL (see FIG. 6B). Meanwhile, in this specification, each of the plurality of pixel regions PXA may correspond to a "pixel." The plurality of pixel regions PXA may be divided to correspond to the pixel opening OP (see FIG. 6B) defined in the pixel-defining film PDL (see FIG. 6B).

As illustrated in FIG. 8A, the third pixel region PXA-B may constitute a first pixel group arranged along the first direction DR1, and the first pixel region PXA-R and the second pixel region PXA-G may constitute a second pixel group in which the first and second pixel regions PXA-R, PXA-G are alternately arranged along the first direction DR1. The first pixel group composed of the third pixel region PXA-B and the second pixel group composed of the first pixel region PXA-R and the second pixel region PXA-G may be spaced apart from each other along the second direction DR2. The first pixel group and the second pixel group may be alternately arranged along the second direction DR2.

The plurality of pixel regions PXA-R, PXA-G, PXA-B may have different areas depending on the wavelength of emitted light. For example, as illustrated in FIG. 8A, the third pixel region PXA-B that emits the third light may have the largest area, and the first pixel region PXA-R that generates the first light may have the smallest area. However, embodiments of the present disclosure are not limited thereto, and the pixel regions PXA-R, PXA-G, and PXA-B may have a same area or may have an area ratio different from that illustrated in FIG. 8A. The plurality of pixel regions PXA-R, PXA-G, and PXA-B may emit light of colors other than light of a red wavelength, light of a green wavelength, and light of a blue wavelength, which are described above.

Each of the plurality of pixel regions PXA-R, PXA-G, and PXA-B may have a rectangular shape with rounded corners on a plane. In one or more embodiments, the first pixel region PXA-R may have a rectangular shape with rounded corners, which has a long side extending in the second direction DR2 and a short side extending in the first direction DR1. In one or more embodiments, each of the second pixel region PXA-G and the third pixel region PXA-B may have a rectangular shape with rounded corners, which has a long side extending in the first direction DR1 and a short side extending in the second direction DR2.

Referring to FIGS. 8A and 8B together, the display panel DP (see FIG.2) according to one or more embodiments is adjacent to each of the plurality of pixel regions PXA-R, PXA-G, and PXA-B, overlaps the non-pixel region NPXA, and includes a valley pattern SP surrounding a portion of each of the plurality of pixel regions PXA-R, PXA-G, and PXA-B. Each valley pattern SP surrounds a portion of each of the plurality of pixel regions PXA-R, PXA-G, and PXA-B and does not surround the remaining portion thereof. In this specification, a portion of the valley pattern SP, which does not surround the plurality of pixel regions PXA-R, PXA-G, and PXA-B, is described as being defined as an "open portion OPP." Meanwhile, the proportion of the open portion OPP in each valley pattern SP may be about 10% to about 50%. If the proportion of the open portion OPP in each valley pattern SP is less than about 10%, a driving voltage may excessively increase so that the efficiency of the display device may decrease. If the proportion of the open portion OPP in each valley pattern SP is greater than about 50%, an excessive lateral leakage current may cause color mixing between adjacent pixels, and accordingly, the optical characteristics of the display device may be deteriorated. Meanwhile, the proportion of the open portion in each valley pattern SP may be referred to as an "opening proportion of the second electrode CE."

Meanwhile, the valley pattern SP is located on the above-described pixel-defining film PDL (see FIG. 6A) or defined in the pixel-defining film PDL (see FIG. 6A). The valley pattern SP may be a component with a surface having a step with the upper surface of the pixel-defining film PDL (see FIG. 6A) in the third direction DR3. On a cross section, the valley pattern SP may have a shape recessed from the upper surface of the pixel-defining film PDL (see FIG. 6A) along the thickness direction of the pixel-defining film PDL (see FIG. 6A).

The valley pattern SP may include a first valley pattern SP1 surrounding a portion of the first pixel region PXA-R, a second valley pattern SP2 surrounding a portion of the second pixel region PXA-G, and a third valley pattern SP3 surrounding a portion of the third pixel region PXA-B. Each of the first valley pattern SP1, the second valley pattern SP2, and the third valley pattern SP3 may surround (e.g., in plan view) a portion of each of the first pixel region PXA-R, the second pixel region PXA-G, and the third pixel region PXA-B and does not surround the remaining portion thereof.

A first open portion OPP1 that does not surround a portion of the first pixel region PXA-R is defined in the first valley pattern SP1, a second open portion OPP2 that does not surround a portion of the second pixel region PXA-G is defined in the second valley pattern SP2, and a third open portion OPP3 that does not surround a portion of the third pixel region PXA-B is defined in the third valley pattern SP3.

In the first valley pattern SP1, the second valley pattern SP2, and the third valley pattern SP3 respectively defined around the first pixel region PXA-R, the second pixel region PXA-G, and the third pixel region PXA-B, which are located to be adjacent to each other, the first open portion OPP1, the second open portion OPP2, and the third open portion OPP3 respectively defined in the first valley pattern SP1, the second valley pattern SP2, and the third valley pattern SP3 are defined so as not to face each other on a plane. In this specification, the expression "the open portions are defined so as not to face each other on a plane" means that the open portions of the valley patterns respectively defined around the pixel regions do not overlap each other in a portion in which the shortest distance between the valley patterns is defined, as illustrated in FIG. 8A, etc. For example, the first open portion OPP1 is defined in the first valley pattern SP1 defined around the first pixel region PXA-R, and an open portion is not defined in each of a portion of the second valley pattern SP2 and a portion of the third valley pattern SP3 closest to a portion in which the first open portion OPP1 is defined. Similarly, an open portion is not defined in each of a portion of the first valley pattern SP1 and a portion of the third valley pattern SP3 closest to a portion in which the second open portion OPP2 is defined, and an open portion is not defined in each of a portion of the first valley pattern SP1 and a portion of the second valley pattern SP2 closest to a portion in which the third open portion OPP3 is defined.

Each of the first open portion OPP1, the second open portion OPP2, and the third open portion OPP3 may be defined on one side of each of the first pixel region PXA-R, the second pixel region PXA-G, and the third pixel region PXA-B. For example, as illustrated in FIGS. 8A and 8B, the first valley pattern SP1 may be located to surround one first pixel region PXA-R, the first open portion OPP1 may be adjacent to a long side extending in the second direction DR2 in the first pixel region PXA-R, the second valley pattern SP2 may be located to surround one second pixel region PXA-G, and the second open portion OPP2 may be adjacent to a long side extending in the first direction DR1 in the second pixel region PXA-G. The third valley pattern SP3 may be located to surround two third pixel regions PXA-B, and the third open portion OPP3 may be adjacent to a short side extending in the second direction DR2 and a long side extending in the first direction DR1 in the third pixel region PXA-B. As illustrated in FIGS. 8A and 8B, the first open portion OPP1 may be adjacent to a long side corresponding to an end in the first direction DR1 in the first pixel region PXA-R, and the second open portion OPP2 may be adjacent to a long side corresponding to an end in the second direction DR2 in the second pixel region PXA-G. The third open portion OPP3 may be adjacent to at least a portion of each of a long side corresponding to an end in the second direction DR2 and a short side corresponding to an end in the first direction DR1 in the third pixel region PXA-B.

In one or more embodiments, in the first pixel region PXA-R, defining a first lateral side SS1 as a short side extending in the first direction DR1, and defining a third lateral side SS3 as a long side extending in the second direction DR2, the first open portion OPP1 may be defined on the third lateral side SS3. In the second pixel region PXA-G, defining a second lateral side SS2 as a long side extending in the first direction DR1, and defining a fourth lateral side SS4 as a short side extending in the second direction DR2, the second open portion OPP2 may be defined on the second lateral side SS2. That is, in the first pixel region PXA-R and the second pixel region PXA-G located adjacent to each other, the extension direction of the first open portion OPP1 defined in the first valley pattern SP1 surrounding the first pixel region PXA-R and the extension direction of the second open portion OPP2 defined in the second valley pattern SP2 surrounding the second pixel region PXA-G may be different from each other.

In the display device according to one or more embodiments, to reduce or prevent a lateral leakage current from occurring between adjacent pixels, the valley pattern SP surrounding a portion of each pixel region is defined. Meanwhile, in this specification, the "lateral leakage current" means a current flowing in another direction crossing the third direction DR3, except a current flowing in the third direction DR3, which is the stacking direction of the light-emitting element, that is, the direction in which an image is displayed. The lateral leakage current may mean a current flowing in a direction parallel to a plane defined by the first direction DR1 and the second direction DR2. Because the valley pattern SP recessed in the thickness direction of the pixel-defining film is defined in the display device according to one or more embodiments, it is possible to reduce or prevent the lateral leakage current from occurring, thereby reducing or preventing luminance decrease as well as color mixing between adjacent pixel regions.

Meanwhile, in the display device according to one or more embodiments, the open portions OPP1, OPP2, and OPP3 are respectively provided in the valley patterns SP to reduce or prevent an excessive increase in a driving voltage. In addition, in the display device described herein, the open portions OPP1, OPP2, and OPP3 may be defined so as not to face each other in the valley patterns SP respectively defined around adjacent pixel regions. If the open portions OPP1, OPP2, and OPP3 face each other, a lateral leakage current may occur between adjacent pixels in which the open portions OPP1, OPP2, and OPP3 facing each other are defined, but by defining the open portions OPP1, OPP2, and OPP3 so as not to face each other in the display device , it is possible to reduce or prevent a current from flowing in the direction of a plane, which is defined by the first direction DR1 and the second direction DR2, other than a desired direction. Accordingly, because an increase in the driving voltage of the display device is reduced or prevented while color mixing between adjacent pixels and luminance decrease are reduced or prevented, the display efficiency of the display device may be improved.

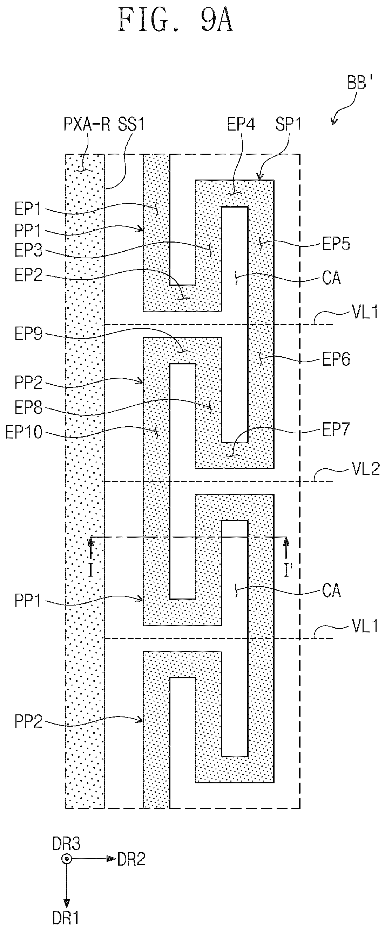

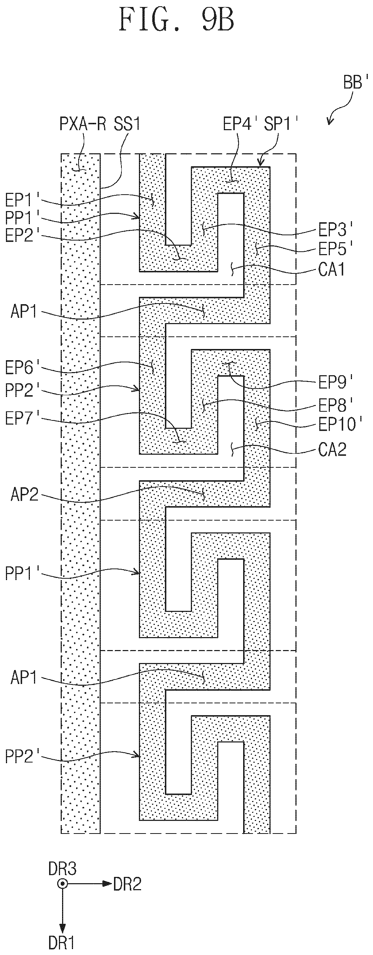

FIGS. 9A and 9B are enlarged plan views of a portion of the display module according to one or more embodiments. Each of FIGS. 9A and 9B enlargedly illustrates a portion of the first pixel region PXA-R and a portion of a first valley pattern SP1 or SP1' adjacent thereto in a region BB' illustrated in FIG. 8B.

Referring to FIG. 9A, the first valley pattern SP1 adjacent to one side of the first pixel region PXA-R includes a first portion PP1. The first valley pattern SP1 adjacent to the one side of the first pixel region PXA-R may further include a second portion PP2 connected to the first portion PP1. The valley pattern SP1 may include the first portion PP1 and the second portion PP2, which are adjacent to the first lateral side SS1 extending in the first direction DR1. Each of the first portion PP1 and the second portion PP2 may be spaced apart from the first lateral side SS1 at a same distance along the second direction DR2. The first portion PP1 and the second portion PP2 may be sequentially arranged along the first direction DR1.

The first portion PP1 may have an S-shape on a plane. The first portion PP1 may have an alphabet S-shape with the upper portion adjacent to the first lateral side SS1. The second portion PP2 may have an inverted S-shape on a plane. The second portion PP2 may have a left-right inverted S-shape with the upper portion adjacent to the first lateral side SS1.

The first portion PP1 and the second portion PP2 may have a symmetrical shape with a virtual axis of symmetry interposed therebetween and extending along the second direction DR2. The second portion PP2 may have a symmetrical shape with the first portion PP1 with respect to a first virtual axis VL1 extending along the second direction DR2.

The first portion PP1 may include a first extension portion EP1, a second extension portion EP2, a third extension portion EP3, a fourth extension portion EP4, and a fifth extension portion EP5, which are connected to each other. With the first extension portion EP1, the second extension portion EP2, the third extension portion EP3, the fourth extension portion EP4, and the fifth extension portion EP5 connected to each other, the first portion PP1 may have an alphabet S-shape on a plane. The first extension portion EP1, the second extension portion EP2, the third extension portion EP3, the fourth extension portion EP4, and the fifth extension portion EP5 may be connected to each other to constitute the first portion PP1 having an integral shape.

The first extension portion EP1 extends in the first direction DR1. The second extension portion EP2 is connected to the first extension portion EP1 and extends in the second direction DR2. The second extension portion EP2 may extend from the first extension portion EP1 in the second direction DR2 so as to be away from the first lateral side SS1. The third extension portion EP3 is connected to the second extension portion EP2 and extends in the first direction DR1. The third extension portion EP3 may be spaced apart from the first extension portion EP1 in the second direction DR2 and be arranged side by side with the first extension portion EP1 at a constant distance.

The fourth extension portion EP4 may be connected to the third extension portion EP3, and may extend in the second direction DR2. The fourth extension portion EP4 may extend from the third extension portion EP3 in the second direction DR2 so as to be away from the first lateral side SS1. The fourth extension portion EP4 may extend in the same direction as the second extension portion EP2 and be spaced apart from the second extension portion EP2 in the first direction DR1. The fifth extension portion EP5 may be connected to the fourth extension portion EP4, and may extend in the first direction DR1. The fifth extension portion EP5 may be spaced apart from the third extension portion EP3 in the second direction DR2 and be arranged side by side with the third extension portion EP3 at a constant distance.

In the first portion PP1, the extension lengths of the extension portions extending in the first direction DR1 may be longer than the extension lengths of the extension portions extending in the second direction DR2. In the first portion PP1, the extension length of each of the second extension portion EP2 and the fourth extension portion EP4 extending in the second direction DR2 may be shorter than the extension length of each of the first extension portion EP1, the third extension portion EP3, and the fifth extension portion EP5 extending in the first direction DR1.

The second portion PP2 may include a sixth extension portion EP6, a seventh extension portion EP7, an eighth extension portion EP8, a ninth extension portion EP9, and a tenth extension portion EP10, which are connected to each other. With the sixth extension portion EP6, the seventh extension portion EP7, the eighth extension portion EP8, the ninth extension portion EP9, and the tenth extension portion EP10 connected to each other, the second portion PP2 may have a left-right inverted alphabet S-shape on a plane. Each of the sixth extension portion EP6, the seventh extension portion EP7, the eighth extension portion EP8, the ninth extension portion EP9, and the tenth extension portion EP10 may be connected to each other to constitute the second portion PP2 having an integral shape.

The sixth extension portion EP6 may extend in the first direction DR1. The sixth extension portion EP6 may be parallel to the fifth extension portion EP5 of the first portion PP1, and the sixth extension portion EP6 and the fifth extension portion EP5 may substantially provide an integral portion extending in the first direction DR1. The seventh extension portion EP7 may be connected to the sixth extension portion EP6, and may extend in the second direction DR2. The seventh extension portion EP7 may extend from the sixth extension portion EP6 in the second direction DR2 so as to be close to the first lateral side SS1. The eighth extension portion EP8 may be connected to the seventh extension portion EP7, and may extend in the first direction DR1. The eighth extension portion EP8 may be spaced apart from the sixth extension portion EP6 in the second direction DR2 and be arranged side by side with the sixth extension portion EP6 at a constant distance.

The ninth extension portion EP9 may be connected to the eighth extension portion EP8, and may extend in the second direction DR2. The ninth extension portion EP9 may extend from the eighth extension portion EP8 in the second direction DR2 so as to be close to the first lateral side SS1. The ninth extension portion EP9 may extend in the same direction as the seventh extension portion EP7 and be spaced apart from the seventh extension portion EP7 in the first direction DR1. The tenth extension portion EP10 may be connected to the ninth extension portion EP9, and may extend in the first direction DR1. The tenth extension portion EP10 may be spaced apart from the eighth extension portion EP8 in the second direction DR2 and be arranged side by side with the eighth extension portion EP8 at a constant distance.

In the second portion PP2, the extension lengths of the extension portions extending in the first direction DR1 may be longer than the extension lengths of the extension portions extending in the second direction DR2. In the second portion PP2, the extension length of each of the seventh extension portions EP7 and the ninth extension portions EP9 extending in the second direction DR2 may be shorter than the extension length of each of the sixth extension portion EP6, the eighth extension portion EP8, and the tenth extension portion EP10 extending in the first direction DR1.

As the first portion PP1 having an S-shape on a plane and the second portion PP2 having an inverted S-shape on a plane are connected to each other, the first valley pattern SP1 may provide a common region CA surrounded by extension portions. In the first valley pattern SP1, the common region CA may be surrounded by the third to eighth extension portions EP3 to EP8. In the common region CA provided by the first valley pattern SP1, common layers, such as the hole transport region HTR (see FIG. 6A), the light-emitting layer EML (see FIG. 6A), and the electron transport region ETR (see FIG. 6A) of the above-described light-emitting element ED or ED-1 (see FIGS. 6A and 7), and layers provided as common layers among the first to third stacks ST1, ST2, and ST3 (see FIG. 7) and as the charge generation layers CGL1 and CGL2 (see FIG. 7), may be arranged having a thickness (e.g., a predetermined thickness).

As the first portion PP1 having an S-shape on a plane and the second portion PP2 having an inverted S-shape on a plane are connected to each other, a portion of the first portion PP1 and a portion of the second portion PP2 are arranged to be adjacent to each other on a plane. As illustrated in FIG. 9A, the second extension portion EP2 of the first portion PP1 and the ninth extension portion EP9 of the second portion PP2 may be arranged to be adjacent to each other on a plane. The second extension portion EP2 and the ninth extension portion EP9 may be spaced apart from each other along the first direction DR1 and be arranged side by side with each other in the second direction DR2 at a constant distance.

In the first valley pattern SP1, a portion of the first portion PP1 and a portion of the second portion PP2 may be aligned with each other in the first direction DR1. The first extension portion EP1 of the first portion PP1 and the tenth extension portion EP10 of the second portion PP2 may be aligned with each other in the first direction DR1. The third extension portion EP3 of the first portion PP1 and the eighth extension portion EP8 of the second portion PP2 may be aligned with each other in the first direction DR1. The fifth extension portion EP5 of the first portion PP1 and the sixth extension portion EP6 of the second portion PP2 may be aligned with each other in the first direction DR1.

In the first valley pattern SP1, each of the first portion PP1 and the second portion PP2 may be provided in plurality. The plurality of first portions PP1 and the plurality of second portions PP2 may be alternately arranged with each other along the first direction DR1. That is, the second portion PP2 may be located between two adjacent first portions PP1 among the plurality of first portions PP1 in the first direction DR1, and the first portion PP1 may be located between two adjacent second portions PP2 among the plurality of second portions PP2 in the first direction DR1. In one or more embodiments, the fifth extension portion EP5 of the first portion PP1 located at the upper portion and the sixth extension portion EP6 of the second portion PP2 located at the lower portion may be connected to each other to have an integral shape. The tenth extension portion EP10 of the second portion PP2 located at the upper portion and the first extension portion EP1 of the first portion PP1 located at the lower portion may be connected to each other to have an integral shape.

With respect to the first direction DR1, a virtual axis of symmetry may be provided between the plurality of first portions PP1 and the plurality of second portions PP2, which are alternately arranged with each other, and a first portion PP1 and a second portion PP2 adjacent to each other may have a symmetrical shape with respect to the axis of symmetry. A first virtual axis VL1 may be provided between the first portion PP1 located at the upper portion and the second portion PP2 located at the lower portion, and the first portion PP1 and the second portion PP2 may have a symmetrical shape with respect to the first virtual axis VL1. A second virtual axis VL2 may be provided between the second portion PP2 located at the upper portion and the first portion PP1 located at the lower portion, and the second portion PP2 and the first portion PP1 may have a symmetrical shape with respect to the second virtual axis VL2.

FIG. 9A illustrates a planar shape of the first valley pattern SP1 adjacent to the first lateral side SS1 of the first pixel region PXA-R, but the first valley pattern SP1 adjacent to the third lateral side SS3 may also have a similar planar shape. Meanwhile, the extension direction of each extension portion included in the first valley pattern SP1 may vary depending on the extension direction of a lateral side adjacent thereto. In one or more embodiments, in the first valley pattern SP1 adjacent to the first lateral side SS1 extending in the first direction DR1, the first extension portion EP1, the third extension portion EP3, the fifth extension portion EP5, the sixth extension portion EP6, the eighth extension portion EP8, and the tenth extension portion EP10 may extend in the first direction DR1, which is the same as the extension direction of the first lateral side SS1, and the second extension portion EP2, the fourth extension portion EP4, the seventh extension portion EP7, and the ninth extension portion EP9 may extend in the second direction DR2 crossing the extension direction of the first lateral side SS1. In the first valley pattern SP1 adjacent to the third lateral side SS3 extending in the second direction DR2, the first extension portion EP1, the third extension portion EP3, the fifth extension portion EP5, the sixth extension portion EP6, the eighth extension portion EP8, and the tenth extension portion EP10 may extend in the second direction DR2, which is the same as the extension direction of the third lateral side SS3, and the second extension portion EP2, the fourth extension portion EP4, the seventh extension portion EP7, and the ninth extension portion EP9 may extend in the first direction DR1 crossing the extension direction of the third lateral side SS3.

In the display device according to one or more embodiments, because the first valley pattern SP1 adjacent to one side of the first pixel region PXA-R includes the first portion PP1 having an S-shape on a plane and the second portion PP2 having a symmetrical shape with the first portion PP1, it is possible to secure a region in which a common layer included in the light-emitting element is arranged having a thickness (e.g., a predetermined thickness), thus improving the display quality of the display device.

In the first valley pattern SP1 according to one or more embodiments, the first portion PP1 includes the first to fifth extension portions EP1 to EP5 so as to have an S-shape on a plane, the second portion PP2 includes the sixth to tenth extension portions EP6 to EP10 so as to have an inverted S-shape on a plane, and a common region CA surrounded by the extension portions of the first portion PP1 and the extension portions of the second portion PP2 is provided. In the common region CA, common layers, such as the hole transport region HTR (see FIG. 6A), the light-emitting layer EML (see FIG. 6A), and the electron transport region ETR (see FIG. 6A) of the above-described light-emitting element ED or ED-1 (see FIGS. 6A and 6B), and layers provided as common layers among the first to third stacks ST1, ST2, and ST3 (see FIG. 7) and as the charge generation layers CGL1 and CGL2 (see FIG. 7), may be arranged having a thickness (e.g., a predetermined thickness). If the area of the common layer of the light-emitting element is excessively small, an overshoot phenomenon may occur in which light greater than a set value is generated because an excessive current is provided during the initial operation of the light-emitting element, but the display module may secure an area, in which the common layer of the light-emitting element is provided with a thickness (e.g., a predetermined thickness), due to the common region CA provided by the first valley pattern SP1, so that it is possible to reduce or prevent the overshoot phenomenon of the display device and improve the display quality thereof.

In addition, , because the first valley pattern SP1 includes the first portion PP1 having an S-shape on a plane and the second portion PP2 having a symmetrical shape with the first portion PP1, it is possible to reduce or prevent a lateral leakage current from occurring between adjacent pixels. In the display device according to one or more embodiments, with the first portion PP1 having an S-shape and the second portion PP2 having an inverted S-shape on a plane, a triple valley pattern structure may be provided in one direction (the first direction DR1 and the second direction DR2), which is away from one side of the first pixel region PXA-R, so that it is possible to reduce or prevent a lateral leakage current from occurring, thus reducing or preventing color mixing between adjacent pixel regions and luminance decrease.

FIG. 9B illustrates the shape of a first valley pattern SP1' according one or more embodiments, which is different from that of FIG. 9A.

Referring to FIG. 9B, the first valley pattern SP1' adjacent to one side of the first pixel region PXA-R includes a first portion PP1'. The first valley pattern SP1' adjacent to one side of the first pixel region PXA-R may further include a second portion PP2' connected to the first portion PP1'. The valley pattern SP1' may include a first portion PP1' and a second portion PP2' adjacent to the first lateral side SS1 extending in the first direction DR1. Each of the first portion PP1' and the second portion PP2' may be spaced apart from the first lateral side SS1 at a same distance along the second direction DR2. The first portion PP1' and the second portion PP2' may be sequentially arranged along the first direction DR1.

The first portion PP1' may have an S-shape on a plane. The first portion PP1' may have an alphabet S-shape with the upper portion adjacent to the first lateral side SS1. The second portion PP2' may have an S-shape on a plane. The second portion PP2' may have an alphabet S-shape with the upper portion adjacent to the first lateral side SS1.

The second portion PP2' may have substantially the same shape as the first portion PP1'. The first valley pattern SP1' may have a shape in which the first and second portions PP1' and PP2' having substantially the same shape as each other are repeatedly arranged along the first direction DR1.

The first portion PP1' may include a first extension portion EP1', a second extension portion EP2', a third extension portion EP3', a fourth extension portion EP4', and a fifth extension portion EP5', which are connected to each other. With the first extension portion EP1', the second extension portion EP2', the third extension portion EP3', the fourth extension portion EP4', and the fifth extension portion EP5' connected to each other, the first portion PP1' may have an alphabet S-shape on a plane.

The first extension portion EP1' extends in the first direction DR1. The second extension portion EP2' may be connected to the first extension portion EP1', and may extend in the second direction DR2. The second extension portion EP2' may extend from the first extension portion EP1' in the second direction DR2 so as to be away from the first lateral side SS1. The third extension portion EP3' is connected to the second extension portion EP2' and extends in the first direction DR1. The third extension portion EP3' may be spaced apart from the first extension portion EP1' in the second direction DR2 and be arranged side by side with the first extension portion EP1' at a constant distance.

The fourth extension portion EP4' may be connected to the third extension portion EP3', and may extend in the second direction DR2. The fourth extension portion EP4' may extend from the third extension portion EP3' in the second direction DR2 so as to be away from the first lateral side SS1. The fourth extension portion EP4' may extend in the same direction as the second extension portion EP2', and the fourth extension portion EP4' and the second extension portion EP2' may be spaced apart from each other in the first direction DR1. The fifth extension portion EP5' may be connected to the fourth extension portion EP4', and may extend in the first direction DR1. The fifth extension portion EP5' may be spaced apart from the third extension portion EP3' in the second direction DR2 and be arranged side by side with the third extension portion EP3' at a constant distance.

In the first portion PP1', the extension lengths of the extension portions extending in the first direction DR1 may be longer than the extension lengths of the extension portions extending in the second direction DR2. In the first portion PP1', the extension length of each of the second extension portion EP2' and the fourth extension portion EP4' extending in the second direction DR2 may be shorter than the extension length of each of the first extension portion EP1', the third extension portion EP3', and the fifth extension portion EP5'.

The second portion PP2' may include a sixth extension portion EP6', a seventh extension portion EP7', an eighth extension portion EP8', a ninth extension portion EP9', and a tenth extension portion EP10', which are connected to each other. With the sixth extension portion EP6', the seventh extension portion EP7', the eighth extension portion EP8', the ninth extension portion EP9', and the tenth extension portion EP10' connected to each other, the second portion PP2' may have an alphabet S-shape on a plane.

The sixth extension portion EP6' may extend in the first direction DR1. The sixth extension portion EP6' may be parallel to the first extension portion EP1' of the first portion PP1'. The seventh extension portion EP7' may be connected to the sixth extension portion EP6', and may extend in the second direction DR2. The seventh extension portion EP7' may extend from the sixth extension portion EP6' in the second direction DR2 so as to be away from the first lateral side SS1. The eighth extension portion EP8' may be connected to the seventh extension portion EP7', and may extend in the first direction DR1. The eighth extension portion EP8' may be spaced apart from the sixth extension portion EP6' in the second direction DR2 and be arranged side by side with the sixth extension portion EP6' at a constant distance.

The ninth extension portion EP9' may be connected to the eighth extension portion EP8', and may extend in the second direction DR2. The ninth extension portion EP9' may extend from the eighth extension portion EP8' in the second direction DR2 so as to be away from the first lateral side SS1. The ninth extension portion EP9' may extend in the same direction as the seventh extension portion EP7', and the ninth extension portion EP9' and the seventh extension portion EP7' may be spaced apart from each other in the first direction DR1. The tenth extension portion EP10' may be connected to the ninth extension portion EP9', and may extend in the first direction DR1. The tenth extension portion EP10' may be spaced apart from the eighth extension portion EP8' in the second direction DR2 and be arranged side by side with the eighth extension portion EP8' at a constant distance.

In the second portion PP2', the extension lengths of the extension portions extending in the first direction DR1 may be longer than the extension lengths of the extension portions extending in the second direction DR2. In the second portion PP2', the extension length of each of the seventh extension portion EP7' and the ninth extension portion EP9' extending in the second direction DR2 may be shorter than the extension length of each of the sixth extension portion EP6', the eighth extension portion EP8', and the tenth extension portion EP10'.

In the first valley pattern SP1', each of the first portion PP1' and the second portion PP2' may be provided in plurality. The plurality of first portions PP1' and the plurality of second portions PP2' may be alternately arranged with each other along the first direction DR1. That is, the second portion PP2' may be located between two adjacent first portions PP1' among the plurality of first portions PP1' in the first direction DR1, and the first portion PP1' may be located between two adjacent second portions PP2' among the plurality of second portions PP2' in the first direction DR1.

With respect to the first direction DR1, Additional extension portions AP1 and AP2 may be provided between the plurality of first portions PP1' and the plurality of second portions PP2', which are alternately arranged with each other. In one or more embodiments, a first additional extension portion AP1 may be located between the first portion PP1' located at the upper portion and the second portion PP2' located at the lower portion, and the first additional extension portion AP1 may connect the fifth extension portion EP5' and the sixth extension portion EP6' to each other. The first additional extension portion AP1 may extend in the second direction DR2. A second additional extension portion AP2 may be located between the second portion PP2' located at the upper portion and the first portion PP1' located at the lower portion, and the second additional extension portion AP2 may connect the tenth extension portion EP10' and the first extension portion EP1' to each other. The second additional extension portion AP2 may extend in the second direction DR2. The additional extension portions AP1 and AP2 may be respectively connected to adjacent first and second portions PP1' and PP2' to have an integral shape.

By the first portion PP1' and the second portion PP2' having an S-shape on a plane, the first valley pattern SP1' according to one or more embodiments may provide common regions CA1 and CA2 surrounded by extension portions. In the first valley pattern SP1', the first common region CA1 may be surrounded by the third to fifth extension portions EP3' to EP5' of the first portion PP1' and the first additional extension portion AP1. In the first valley pattern SP1', the second common region CA2 may be surrounded by the eighth to tenth extension portions EP8' to EP10' of the second portion PP2' and the second additional extension portion AP2. In the common regions CA1 and CA2 provided by the first valley pattern SP1', common layers, such as the hole transport region HTR (see FIG. 6A), the light-emitting layer EML (see FIG. 6A), and the electron transport region ETR (see FIG. 6A) of the above-described light-emitting element ED or ED-1 (see FIGS. 6A and 7), and layers provided as common layers among the first to third stacks ST1, ST2, and ST3 (see FIG. 7) and as the charge generation layers CGL1 and CGL2 (see FIG. 7), may be arranged having a thickness (e.g., a predetermined thickness).

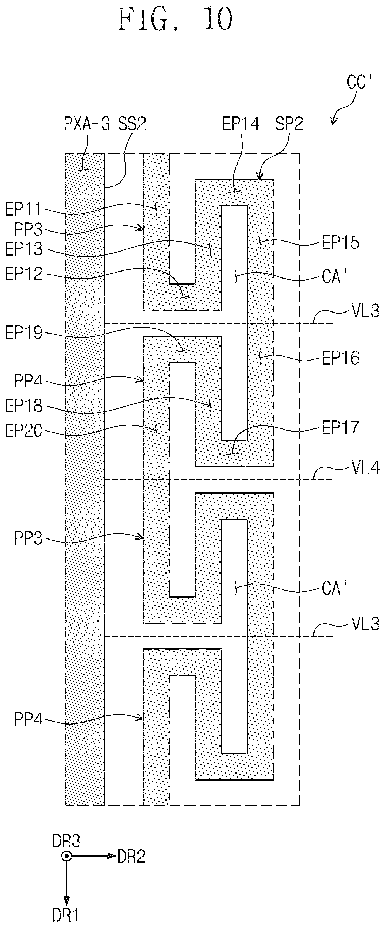

FIG. 10 is an enlarged plan view of a portion of the display module according to one or more embodiments. FIG. 10 enlargedly illustrates a portion of the second pixel region PXA-G and a portion of the second valley pattern SP2 adjacent thereto in a region CC' illustrated in FIG. 8B.

Referring to FIG. 10, the second valley pattern SP2 adjacent to one side of the second pixel region PXA-G may have substantially the same shape as the first valley pattern SP1 described above in FIG. 9A.

The second valley pattern SP2 adjacent to one side of the second pixel region PXA-G includes a third portion PP3. The second valley pattern SP2 adjacent to the one side of the second pixel region PXA-G may further include a fourth portion PP4 connected to the third portion PP3. The second pixel region PXA-G may include a third portion PP3 and a fourth portion PP4 adjacent to a second lateral side SS2 extending in the first direction DR1. Each of the third portion PP3 and the fourth portion PP4 may be spaced apart from the second lateral side SS2 at a same distance along the second direction DR2. The third portion PP3 and the fourth portion PP4 may be sequentially arranged along the first direction DR1.

The third portion PP3 may have an S-shape on a plane. The third portion PP3 may have an alphabet S-shape with the upper portion adjacent to the second lateral side SS2. The fourth portion PP4 may have an inverted S-shape on a plane. The fourth portion PP4 may have a left-right inverted S-shape with the upper portion adjacent to the second lateral side SS2.

The third portion PP3 and the fourth portion PP4 may have a symmetrical shape with respect to a virtual axis of symmetry, which extends along the second direction DR2 and is interposed therebetween. The fourth portion PP4 may have a symmetrical shape with the third portion PP3 with respect to a third virtual axis VL3 extending along the second direction DR2.

The third portion PP3 may include an eleventh extension portion EP11, a twelfth extension portion EP12, a thirteenth extension portion EP13, a fourteenth extension portion EP14, and a fifteenth extension portion EP15, which are connected to each other. With the eleventh extension portion EP11, the twelfth extension portion EP12, the thirteenth extension portion EP13, the fourteenth extension portion EP14, and the fifteenth extension portion EP15 connected to each other, the third portion PP3 may have an alphabet S-shape on a plane.

The eleventh extension portion EP11 extends in the first direction DR1. The twelfth extension portion EP12 is connected to the eleventh extension portion EP11 and extends in the second direction DR2. The thirteenth extension portion EP13 is connected to the twelfth extension portion EP12 and extends in the first direction DR1. The thirteenth extension portion EP13 may be spaced apart from the eleventh extension portion EP11 in the second direction DR2 and be arranged side by side with the eleventh extension portion EP11 at a constant distance.

The fourteenth extension portion EP14 may be connected to the thirteenth extension portion EP13, and may extend in the second direction DR2. The fourteenth extension portion EP14 may extend in the same direction as the twelfth extension portion EP12, and the fourteenth extension portion EP14 and the twelfth extension portion EP12 may be spaced apart from each other along the first direction DR1. The fifteenth extension portion EP15 may be connected to the fourteenth extension portion EP14, and may extend in the first direction DR1. The fifteenth extension portion EP15 may be spaced apart from the thirteenth extension portion EP13 in the second direction DR2 and be arranged side by side with the thirteenth extension portion EP13 at a constant distance.

In the third portion PP3, the extension lengths of the extension portions extending in the first direction DR1 may be longer than the extension lengths of the extension portions extending in the second direction DR2. In the third portion PP3, the extension length of each of the twelfth extension portion EP12 and the fourteenth extension portion EP14 extending in the second direction DR2 may be shorter than the extension length of each of the eleventh extension portion EP11, the thirteenth extension portion EP13, and the fifteenth extension portion EP15.

The fourth portion PP4 may include a sixteenth extension portion EP16, a seventeenth extension portion EP17, an eighteenth extension portion EP18, a nineteenth extension portion EP19, and a twentieth extension portion EP20, which are connected to each other. With the sixteenth extension portion EP16, the seventeenth extension portion EP17, the eighteenth extension portion EP18, the nineteenth extension portion EP19, and the twentieth extension portion EP20 connected to each other, the fourth portion PP4 may have a left-right inverted alphabet S-shape on a plane.

The sixteenth extension portion EP16 may extend in the first direction DR1. The sixteenth extension portion EP16 may be parallel to the fifteenth extension portion EP15 of the third portion PP3 and substantially provide an integral portion extending in the first direction DR1. The seventeenth extension portion EP17 may be connected to the sixteenth extension portion EP16, and may extend in the second direction DR2. The eighteenth extension portion EP18 may be connected to the seventeenth extension portion EP17, and may extend in the first direction DR1. The eighteenth extension portion EP18 may be spaced apart from the sixteenth extension portion EP16 in the second direction DR2 and be arranged side by side with the sixteenth extension portion EP16 at a constant distance.

The nineteenth extension portion EP19 may be connected to the eighteenth extension portion EP18, and may extend in the second direction DR2. The nineteenth extension portion EP19 may extend in the same direction as the seventeenth extension portion EP17, and the nineteenth extension portion EP19 and the seventeenth extension portion EP17 may be spaced apart from each other along the first direction DR1. The twentieth extension portion EP20 may be connected to the nineteenth extension portion EP19, and may extend in the first direction DR1. The twentieth extension portion EP20 may be spaced apart from the eighteenth extension portion EP18 in the second direction DR2 and be arranged side by side with the eighteenth extension portion EP18 at a constant distance.

In the fourth portion PP4, the extension lengths of the extension portions extending in the first direction DR1 may be longer than the extension lengths of the extension portions extending in the second direction DR2. In the fourth portion PP4, the extension length of each of the seventeenth extension portions EP17 and the nineteenth extension portions EP19 extending in the second direction DR2 may be shorter than the extension length of each of the sixteenth extension portion EP16, the eighteenth extension portion EP18, and the twentieth extension portion EP20.

As the third portion PP3 having an S-shape on a plane and the fourth portion PP4 having an inverted S-shape on a plane are connected to each other, the second valley pattern SP2 according to one or more embodiments may provide a common region CA' surrounded by extension portions. In the second valley pattern SP2, the common region CA' may be surrounded by the thirteenth to eighteenth extension portions EP13 to EP18. In the common region CA' provided by the second valley pattern SP2, common layers, such as the hole transport region HTR (see FIG. 6A), the light-emitting layer EML (see FIG. 6A), and the electron transport region ETR (see FIG. 6A) of the above-described light-emitting element ED or ED-1 (see FIGS. 6A and 7), and layers provided as common layers among the first to third stacks ST1, ST2, and ST3 (see FIG. 7) and the charge generation layers CGL1 and CGL2 (see FIG. 7) may be arranged having a thickness (e.g., a predetermined thickness).

As the third portion PP3 having an S-shape on a plane and the fourth portion PP4 having an inverted S-shape on a plane are connected to each other, a portion of the third portion PP3 and a portion of the fourth portion PP4 are arranged to be adjacent to each other on a plane. As illustrated in FIG. 10, the twelfth extension portion EP12 of the third portion PP3 and the nineteenth extension portion EP19 of the fourth portion PP4 may be arranged to be adjacent to each other on a plane. The 12th extension portion EP12 and the 19th extension portion EP19 may be spaced apart from each other along the first direction DR1 and be arranged side by side with each other in the second direction DR2 at a constant distance.

In the second valley pattern SP2, a portion of the third portion PP3 and a portion of the fourth portion PP4 may be aligned with each other in the first direction DR1. The eleventh extension portion EP11 of the third portion PP3 and the twentieth extension portion EP20 of the fourth portion PP4 may be aligned with each other in the first direction DR1. The thirteenth extension portion EP13 of the third portion PP3 and the eighteenth extension portion EP18 of the fourth portion PP4 may be aligned with each other in the first direction DR1. The fifteenth extension portion EP15 of the third portion PP3 and the sixteenth extension portion EP16 of the fourth portion PP4 may be aligned with each other in the first direction DR1.

In the second valley pattern SP2, each of the third portion PP3 and the fourth portion PP4 may be provided in plurality. The plurality of third portions PP3 and the plurality of fourth portions PP4 may be alternately arranged with each other along the first direction DR1. That is, the fourth portion PP4 may be located between two adjacent third portions PP3 among the plurality of third portions PP3 in the first direction DR1, and the third portion PP3 may be located between two adjacent fourth portions PP4 among the plurality of fourth portions PP4 in the first direction DR1. In one or more embodiments, the fifteenth extension portion EP15 of the third portion PP3 located at the upper portion and the sixteenth extension portion EP16 of the fourth portion PP4 at the lower portion may be connected to each other to have an integral shape. The twentieth extension portion EP20 of the fourth portion PP4 located at the upper portion and the eleventh extension portion EP11 of the third portion PP3 located at the lower portion may be connected to each other to have an integral shape.

With respect to the first direction DR1, a virtual axis of symmetry may be provided between the plurality of third portions PP3 and the plurality of fourth portions PP4, which are alternately arranged with each other, and a third portion PP3 and a fourth portion PP4 adjacent to each other may have a symmetrical shape with respect to the axis of symmetry. A third virtual axis VL3 may also be provided between the third portion PP3 located at the upper portion and the fourth portion PP4 located at the lower portion, and the third portion PP3 and the fourth portion PP4 may have a symmetrical shape with respect to the third virtual axis VL3. A fourth virtual axis VL4 may also be provided between the fourth portion PP4 located at the upper portion and the third portion PP3 located at the lower portion, and the fourth portion PP4 and the third portion PP3 may have a symmetrical shape with respect to the fourth virtual axis VL4.

FIG. 10 illustrates the planar shape of the second valley pattern SP2 adjacent to the second lateral side SS2 of the second pixel region PXA-G, but the second valley pattern SP2 adjacent to the fourth lateral side SS4 may also have a similar planar shape. Meanwhile, the extension direction of each extension portion included in the second valley pattern SP2 may vary depending on the extension direction of a lateral side adjacent thereto. In one or more embodiments, in the second valley pattern SP2 adjacent to the second lateral side SS2 extending in the first direction DR1, the eleventh extension portion EP11, the thirteenth extension portion EP13, the fifteenth extension portion EP15, the sixteenth extension portion EP16, the eighteenth extension portion EP18, and the twentieth extension portion EP20 may extend in the first direction DR1, which is the same as the extension direction of the second lateral side SS2, and the twelfth extension portion EP12, the fourteenth extension portion EP14, the seventeenth extension portion EP17, and the nineteenth extension portion EP19 may extend in the second direction DR2 crossing the extension direction of the second lateral side SS2. In the second valley pattern SP2 adjacent to the fourth lateral side SS4 extending in the second direction DR2, the eleventh extension portion EP11, the thirteenth extension portion EP13, the fifteenth extension portion EP15, the sixteenth extension portion EP16, the eighteenth extension portion EP18, and the twentieth extension portion EP20 may extend in the second direction DR2, which is the same as the extension direction of the fourth lateral side SS4, and the twelfth extension portion EP12, the fourteenth extension portion EP14, the seventeenth extension portion EP17, and the nineteenth extension portion EP19 may extend in the first direction DR1 crossing the extension direction of the fourth lateral side SS4.

Meanwhile, FIGS. 9A and 9B illustrate planar shapes of the first valley patterns SP1 and SP1' adjacent to the first pixel region PXA-R, and FIG. 10 illustrates a planar shape of the second valley pattern SP2 adjacent to the second pixel region PXA-G. In one or more embodiments, the third valley pattern SP3 may have substantially the same shape as the planar shape of the first valley patterns SP1 and SP1' illustrated in FIGS. 9A and 9B or the planar shape of the second valley pattern SP2 illustrated in FIG. 10.

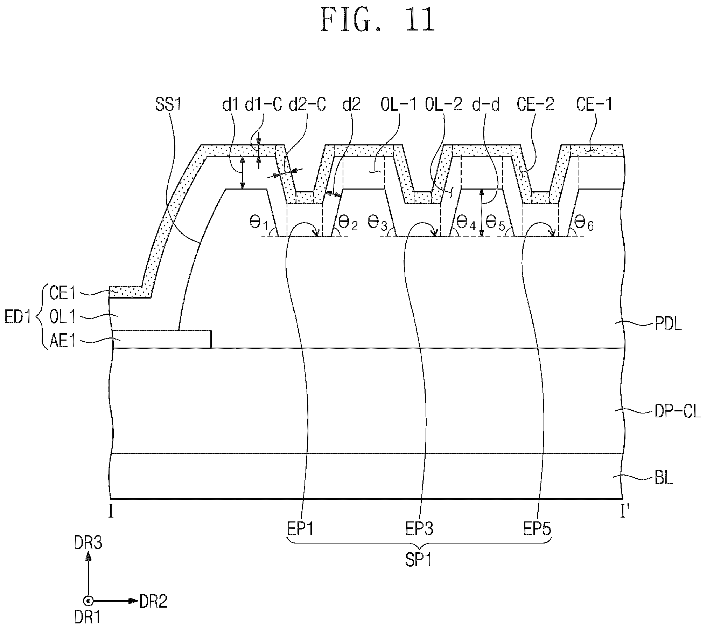

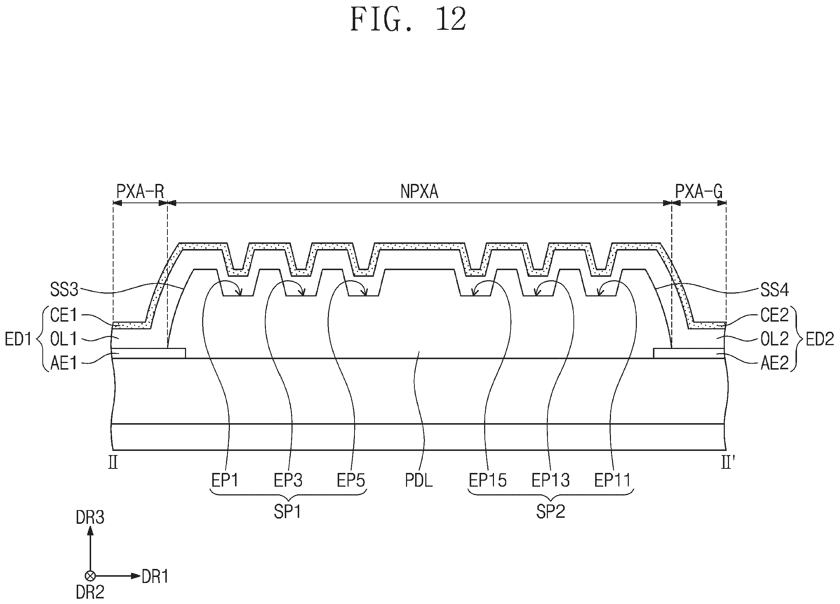

FIGS. 11 and 12 are cross-sectional views of a portion of the display module according to one or more embodiments. FIG. 11 illustrates a cross section corresponding to line I-I' illustrated in FIG. 9A, and FIG. 12 illustrates a cross section corresponding to line II-II' illustrated in FIG. 8B.

Referring to FIGS. 8B, 9A, 11, and 12 together, the display panel according to one or more embodiments includes a base layer BL, a circuit layer DP-CL located on the base layer BL, and a light-emitting element layer DP-ED. In one or more embodiments in FIGS. 8B, 9A, and 9B, an upper insulating layer TFL (see FIG. 2A) may be further located on the light-emitting element layer DP-ED.

Light-emitting elements ED1 and ED2 located on the circuit layer DP-CL may include first electrodes AE1 and AE2, organic layers OL1 and OL2, and second electrodes CE1 and CE2. The light-emitting elements ED1 and ED2 may include a first light-emitting element ED1 overlapping the first pixel region PXA-R and a second light-emitting element ED2 overlapping the second pixel region PXA-G. The organic layers OL1 and OL2 respectively included in the first light-emitting element ED1 and the second light-emitting element ED2 may include at least a light-emitting layer EML (see FIG. 6A). For example, the organic layers OL1 and OL2 may include a hole transport region HTR, a light-emitting layer EML, and an electron transport region ETR sequentially stacked as described above in FIG. 6A. Alternatively, as described above in FIG. 7, the organic layers OL1 and OL2 may include the plurality of light-emitting stacks ST1, ST2, and ST3 and the charge generation layers CGL1 and CGL2 located between the plurality of light-emitting stacks ST1, ST2, and ST3, which are sequentially stacked.

The valley patterns SP1 and SP2 overlapping the non-pixel region NPXA are defined in the pixel-defining film PDL located on the circuit layer DP-CL. As illustrated in FIGS. 11 and 12, the valley patterns SP1 and SP2 may have a shape recessed from the upper surface of the pixel-defining film PDL in the third direction DR3, which is the thickness direction. Meanwhile, in the following description, the first valley pattern SP1 and the second valley pattern SP2 are referred to as "valley patterns" and the depth and taper angle thereof are exemplarily described, but the same description may be applied to the third valley pattern SP3.

As described above, the first valley pattern SP1 may include first to tenth extension portions EP1 to EP10, and each of the first to tenth extension portions EP1 to EP10 may have a shape recessed from the upper surface of the pixel-defining film PDL in the third direction DR3, which is the thickness direction. The second valley pattern SP2 may include eleventh to twentieth extension portions EP11 to EP20, and each of the eleventh to twentieth extension portions EP11 to EP20 may have a shape recessed from the upper surface of the pixel-defining film PDL in the third direction DR3, which is the thickness direction. Meanwhile, although FIGS. 11 and 12 illustrate only the cross-sectional shapes of the first extension portion EP1, the third extension portion EP3, and the fifth extension portion EP5 of the first valley pattern SP1, the second extension portion EP2, the fourth extension portion EP4, and the sixth to tenth extension portions EP6 to EP10 may also have a shape similarly recessed from the upper portion of the pixel-defining film PDL. Although FIG. 12 illustrates only the cross-sectional shapes of the eleventh extension portion EP11, the thirteenth extension portion EP13, and the fifteenth extension portion EP15 of the second valley pattern SP2, the twelfth extension portion EP12, the fourteenth extension portion EP14, and the sixteenth to twentieth extension portions EP16 to EP20 may also have a shape similarly recessed from the upper portion of the pixel-defining film PDL.

Referring to FIG. 11, a recess depth d-d of each of the extension portions EP1, EP3, and EP5 included in the valley pattern SP1 may be about 100 nm to about 500 nm. If the recess depth d-d is less than about 100 nm, the degree of reducing the thickness of the organic layer OL1 and the second electrode CE1 located on the pixel-defining film PDL is so small that the aspect of reducing or preventing a lateral leakage current may be inhibited. If the recess depth d-d is greater than about 500 nm, the organic layer OL1 and the second electrode CE1 located on the pixel-defining film PDL may be damaged.

The valley pattern SP1 having a recessed shape may include a lower surface and a side surface, and the side surface may have a shape inclined at an angle (e.g., a predetermined angle) with respect to the lower surface. In one or more embodiments, taper angles θ1 to θ6 at which the side surface is inclined from the lower surface may be about 70 degrees to about 90 degrees. If the taper angles θ1 to θ6 are less than about 70 degrees, the degree of reducing the thickness of the organic layer OL1 and the second electrode CE1 located on the pixel-defining film PDL is so small that the aspect of reducing or preventing a lateral leakage current may be inhibited. If the taper angle θ1 to θ6 is greater than about 90 degrees, the side surface of the valley pattern SP1 may have a reverse taper structure, and therefore damage, such as a crack, may occur in the upper insulating layer TFL (see FIG. 6A) located thereon.

Meanwhile, among two side surfaces that define each valley pattern SP1, the taper angles θ1, θ3, and 85 of the side surface adjacent to the light-emitting element ED1 and the taper angles θ2, θ4, and θ6 of the side surface spaced apart from the light-emitting element ED1 may be different from each other. The taper angles θ1, θ3, and θ5 of the side surface adjacent to the light-emitting element ED1 may be less than the taper angles θ2, θ4, and θ6 of the side surface spaced apart from the light-emitting element ED1. In each of the extension portions EP1, EP3, and EP5 included in the valley pattern SP1, the taper angle θ1 of the side surface of the first extension portion EP1 adjacent to the light-emitting element ED1 may be less than the taper angle θ2 of the side surface of the first extension portion EP1 spaced apart from the light-emitting element ED1. The taper angle θ3 of the side surface of the third extension portion EP3 adjacent to the light-emitting element ED1 may be less than the taper angle θ4 of the side surface of the third extension portion EP3 spaced apart from the light-emitting element ED1. The taper angle θ5 of the side surface of the fifth extension portion EP5 adjacent to the light-emitting element ED1 may be less than the taper angle θ6 of the side surface of the fifth extension portion EP5 spaced apart from the light-emitting element ED1.

A portion of the organic layer OL1 and the second electrode CE1 may be located inside the valley pattern SP1.

In one or more embodiments, the organic layer OL1 may include a first organic portion OL-1 located on the upper surface of the pixel-defining film PDL and a second organic portion OL-2 located on the side surface of the valley pattern SP1. The second electrode CE1 may include a first electrode portion CE-1 located on the first organic portion OL-1 and a second electrode portion CE-2 located on the second organic portion OL-2.

In one or more embodiments, a thickness d2 of the second organic portion OL-2 may be less than a thickness d1 of the first organic portion OL-1. The thickness d2 of the second organic portion OL-2 may be about 10% to about 20% of the thickness d1 of the first organic portion OL-1. In one or more embodiments, the thickness d1 of the first organic portion OL-1 may be about 200 nm to about 300 nm, and the thickness d2 of the second organic portion OL-2 may be about 30 nm to about 55 nm.

In one or more embodiments, a thickness d2-C of the second electrode portion CE-2 may be less than a thickness d1-C of the first electrode portion CE-1. The thickness d2-C of the second electrode portion CE-2 may be about 10% to about 20% of the thickness d1-C of the first electrode portion CE-1. In one or more embodiments, the thickness d1-C of the first electrode portion CE-1 is about 90 Å to about 120 Å, and the thickness d2-C of the second electrode portion CE-2 is about 10 Å to about 35 Å.

In the display device according to one or more embodiments, as the valley pattern SP1 is provided in a shape recessed in the thickness direction of the pixel-defining film PDL, the second organic portion OL-2 of the organic layer OL1 located on the side surface of the valley pattern SP1 and the second electrode portion CE-2 of the second electrode CE1 may be arranged to be thin. As each of the second organic portion OL-2 and the second electrode portion CE-2 becomes thinner, the resistance of the second organic portion OL-2 and the second electrode portion CE-2 increases, and as a result, it is possible to reduce or prevent a current from being leaked to a portion in which the valley pattern SP2 has increased resistance.

Meanwhile, a portion in which the open portions OPP1, OPP2, and OPP3 described above in FIGS. 8A and 8B are located may be a portion in which the upper surface of the pixel-defining film PDL is not recessed and maintains a flat upper surface. Therefore, in the portion in which the open portions OPP1, OPP2, and OPP3 are located, the aspect of reducing the thickness of the organic layer OL1 and the second electrode CE1 due to the valley pattern may be inhibited.

Referring to FIG. 12, in the pixel-defining film PDL between the first pixel region PXA-R and the second pixel region PXA-G adjacent to each other in one direction, that is, the first direction DR1, a first valley pattern SP1 and a second valley pattern SP2 having a shape in which the upper surface of the pixel-defining film PDL is recessed may be provided. Meanwhile, triple valley pattern structures spaced apart from each other along the first direction DR1, which is the separation direction of the first pixel region PXA-R and the second pixel region PXA-G, may be respectively provided in the valley patterns SP1 and SP2. That is, as illustrated in FIG. 12, the first valley pattern SP1 may include a first extension portion EP1, a third extension portion EP3, and a fifth extension portion EP5 spaced apart from each other along the the first direction DR1on a cross section, and the second valley pattern SP2 may include an eleventh extension portion EP11, a thirteenth extension portion EP13, and a fifteenth extension portion EP15 spaced apart from each other along the first direction DR1on a cross section. In the display device according to one or more embodiments, because the valley patterns SP1 and SP2 including triple valley pattern structures between the pixel regions PXA-R and PXA-G arranged to be adjacent to each other in one direction are provided, it is possible to effectively reduce or prevent a lateral leakage current from occurring between adjacent pixels, thus reducing or preventing color mixing between adjacent pixel regions and luminance decrease.

As discussed, embodiments can provide a display device comprising: a base layer having a first pixel region comprising a first lateral side extending in a first direction, a second pixel region adjacent to the first pixel region, and a non-pixel region surrounding the first pixel region and the second pixel region; a pixel-defining film above the base layer, overlapping the non-pixel region, defining a pixel opening therein and corresponding to the first pixel region or the second pixel region, and defining a first valley pattern overlapping the non-pixel region and surrounding a portion of the first pixel region in plan view, a first portion of the first valley pattern adjacent to the first lateral side comprising a first extension portion extending along the first direction, a second extension portion extending from the first extension portion in a second direction crossing the first direction so as to be away from the first lateral side, and a third extension portion extending from the second extension portion in the first direction and parallel to the first extension portion; and a light-emitting element layer at least partially within the pixel opening.

The first lateral side may extend in the first direction.

The first pixel region may be generally tetragonal in shape, with the first lateral side being opposite another lateral side extending in the first direction. In such embodiments, a pair of lateral sides extend in the second direction. For example, the generally tetragonal shape may be a rectangle with the first lateral side being a short side.

The generally tetragonal shape may have rounded corners, for example a rectangle with rounded corners.

The second pixel region may be adjacent to the first pixel region in the first direction. A plurality of first pixel regions and second pixel regions may be provided, with the first and second pixel regions being alternately arranged along the first direction.

A third pixel region may be provided that is adjacent the first and second pixel regions in the second direction. A plurality of third pixel regions and second pixel regions may be provided, with the third regions being arranged along the first direction.

The first valley pattern may partially surround the first pixel region, with open portions where the first valley pattern does not surround the first pixel region. For example, the first valley pattern may have two open portions, each being present on a lateral side extending in the second direction.

The pixel-defining film may further define a second valley pattern overlapping the non-pixel region, and surrounding a portion of the second pixel region in plan view.

The second valley pattern may partially surround the second pixel region, with open portions where the second valley pattern does not surround the second pixel region. For example, the second valley pattern may have two open portions, each being present on a lateral side extending in the first direction. As a result, in such embodiments, the open portions of the second valley pattern do not face the open portions of the first valley pattern.

The pixel-defining film may further define a third valley pattern overlapping the non-pixel region, and surrounding a portion of the third pixel region in plan view.

The third valley pattern may partially surround the third pixel region, with open portions where the third valley pattern does not surround the third pixel region. In some embodiments, the open portions of the third valley pattern do not face the open portions of the first or second valley patterns.

As for the display device according to one or more embodiments, a lateral leakage current may be prevented by a valley pattern defined between adjacent pixels, while it is possible to reduce or prevent an overshoot phenomenon in which light greater than a set value is generated because an excessive current is provided during the initial operation of the light-emitting element. Accordingly, the display device according to one or more embodiments may reduce or prevent color mixing between adjacent pixels and a display defect during initial operation, thereby improving the display quality of the display device.

Although the above has been described with reference to embodiments of the present disclosure, those skilled in the art or those of ordinary skill in the art will understand that various modifications and changes can be made to the present disclosure within the scope that does not depart from the aspects of the present disclosure described in the claims. Accordingly, the present disclosure should not be limited to the content described in the detailed description of the specification, but should be determined by the claims described hereinafter, with functional equivalents thereof to be included therein.

## Claims

1. A display device comprising:
a base layer having a first pixel region comprising a first lateral side extending in a first direction, a second pixel region adjacent to the first pixel region, and a non-pixel region surrounding the first pixel region and the second pixel region;
a pixel-defining film over the base layer, overlapping the non-pixel region, defining a pixel opening therein and corresponding to the first pixel region or the second pixel region, the pixel-defining film defining a first valley pattern overlapping the non-pixel region and surrounding a portion of the first pixel region in plan view, a first portion of the first valley pattern adjacent to the first lateral side comprising a first extension portion extending along the first direction, a second extension portion extending from the first extension portion in a second direction crossing the first direction so as to be away from the first lateral side, and a third extension portion extending from the second extension portion in the first direction and parallel to the first extension portion; and
a light-emitting element layer at least partially within the pixel opening.

2. The display device of claim 1, wherein a length of the second extension portion in the second direction is less than a length of the first extension portion in the first direction.

3. The display device of claim 1 or 2, wherein the first portion further comprises:
a fourth extension portion extending from the third extension portion in the second direction so as to be away from the first lateral side; and
a fifth extension portion extending from the fourth extension portion in the first direction and parallel to the third extension portion.

4. The display device of claim 3, wherein the first valley pattern further comprises a second portion connected to the first portion on a plane, and
wherein the second portion comprises:
a sixth extension portion extending from the fifth extension portion in the first direction;
a seventh extension portion extending from the sixth extension portion in the second direction toward the first lateral side;
an eighth extension portion extending from the seventh extension portion in the first direction and parallel to the sixth extension portion;
a ninth extension portion extending from the eighth extension portion in the second direction toward the first lateral side; and
a tenth extension portion extending from the ninth extension portion in the first direction and parallel to the eighth extension portion.

5. The display device of claim 4, wherein the second extension portion and the ninth extension portion are spaced apart at a constant distance.

6. The display device of claim 4 or 5, wherein:
the first extension portion and the tenth extension portion are aligned in the first direction;
the third extension portion and the eighth extension portion are aligned in the first direction; and
the fifth extension portion and the sixth extension portion are aligned in the first direction.

7. The display device of any one of claims 1 to 6, wherein the first valley pattern has a shape recessed from an upper surface of the pixel-defining film along a thickness direction of the pixel-defining film.

8. The display device of claim 7, wherein a depth of the first valley pattern recessed from the upper surface of the pixel-defining film is from about 100 nm to about 500 nm.

9. The display device of claim 7 or 8, wherein:
the first valley pattern comprises a lower surface parallel to the upper surface of the pixel-defining film, and a side surface connecting the lower surface to the upper surface of the pixel-defining film; and
an angle at which the side surface is inclined from the lower surface is from about 70 degrees to about 90 degrees.

10. The display device of claim 9, wherein the light-emitting element layer comprises:
a first electrode over the base layer;
an organic layer over the first electrode and the pixel-defining film and comprising a light-emitting layer; and
a second electrode over the organic layer,
wherein a portion of the organic layer and the second electrode is within the first valley pattern.

11. The display device of claim 10, wherein the organic layer comprises:
a first organic portion over the upper surface of the pixel-defining film; and
a second organic portion on the side surface, and having a thickness that is less than a thickness of the first organic portion.

12. The display device of claim 10 or 11, wherein the second electrode comprises:
a first electrode portion over the upper surface of the pixel-defining film; and
a second electrode portion on the side surface, and having a thickness that is less than a thickness of the first electrode portion.

13. The display device of any one of claims 10 to 12, wherein the organic layer comprises:
a first light-emitting stack over the first electrode and the pixel-defining film, and comprising a first light-emitting layer;
a first charge generation layer over the first light-emitting stack; and
a second light-emitting stack between the first charge generation layer and the second electrode, and comprising a second light-emitting layer.

14. The display device of any one of claims 1 to 13, wherein:
the pixel-defining film further defines a second valley pattern overlapping the non-pixel region, and surrounding a portion of the second pixel region in plan view; and
a first open portion in which the first valley pattern does not surround the first pixel region does not face a second open portion in which the second valley pattern does not surround the second pixel region.

15. The display device of any one of claims 1 to 14, wherein:
the base layer further has a third pixel region adjacent to the second pixel region;
the pixel-defining film further defines a third valley pattern overlapping the non-pixel region, and surrounding a portion of the third pixel region in plan view;
the first pixel region is configured to emit a first light;
the second pixel region is configured to emit a second light of a wavelength different from that of the first light; and
the third pixel region is configured to emit a third light of a wavelength different from those of the first light and the second light.
